(19) Europäisches Patentamt
European Patent Office
Office européen des brevets

(11) EP 2 554 381 B1

(12) **EUROPEAN PATENT SPECIFICATION**

(45) Date of publication and mention of the grant of the patent:
**02.05.2018 Bulletin 2018/18**

(21) Application number: **11762611.9**

(22) Date of filing: **18.03.2011**

(51) Int Cl.:
***B41C 1/10*** *(2006.01)*
***G03F 7/027*** *(2006.01)*
***G03F 7/038*** *(2006.01)*
***G03F 7/09*** *(2006.01)*
***G03F 7/30*** *(2006.01)*

(86) International application number:
**PCT/JP2011/056634**

(87) International publication number:
**WO 2011/122378 (06.10.2011 Gazette 2011/40)**

(54) **METHOD FOR PRODUCING LITHOGRAPHIC PRINTING PLATE**

VERFAHREN ZUR HERSTELLUNG EINER LITHOGRAFIEDRUCKPLATTE

PROCÉDÉ DE PRODUCTION D'UNE PLAQUE D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.02.2011 JP 2011021229**
**30.03.2010 JP 2010079921**

(43) Date of publication of application:
**06.02.2013 Bulletin 2013/06**

(73) Proprietor: **FUJIFILM Corporation**
**Tokyo 106-0031 (JP)**

(72) Inventor: **SONOKAWA Koji**
**Haibara-gun**
**Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A1- 2 554 395**
**WO-A1-2008/156552**
**WO-A2-03/087939**
**JP-A- 2000 039 711**
**JP-A- 2002 103 837**
**JP-A- 2007 224 229**
**JP-A- 2008 230 208**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

TECHNICAL FIELD

The present invention relates to a plate making method of a lithographic printing plate. More particularly, it relates to a plate making method in which a lithographic printing plate precursor is subjected to UV exposure through a lith film and on-press development.

BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is heretofore used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing process.

In the simplification of plate making operation as described above, a system using a lithographic printing plate precursor capable of being handled in a bright room or under a yellow lamp and a light source is preferred from the standpoint of workability. Thus, as the light source, a semiconductor laser emitting an infrared ray having a wavelength of 760 to 1,200 is used. An UV laser is also used.

While the technology progresses as above, a plate making method in which a PS plate is subjected to UV exposure through a mask, for example, a lith film and then development processing, for example, with an alkaline developer remains in the market. Therefore, in the market there is a need for a lithographic printing plate precursor which is capable of undergoing not only exposure with a semiconductor laser emitting an infrared ray having a wavelength from 760 to 1,200 nm but also UV exposure through a mask, for example, a lith film, and on-press development.

As the lithographic printing plate precursor which is suitable for exposure with a semiconductor laser emitting an infrared ray and capable of undergoing on-press development, for example, a lithographic printing plate precursor having provided on a hydrophilic support, an image-recording layer (heat-sensitive layer) containing an infrared absorbing dye, a polymerization initiator, a polymerizable compound and a microcapsule having a polymerizable compound encapsulated therein or a polymer particle having a polymerizable group is described in Patent Documents 1 and 2. However, the lithographic printing plate precursor is insufficient in the printing durability even by the exposure with a semiconductor laser emitting an infrared ray, and is also insufficient in the on-press development property. In addition, it does not form an image by the UV exposure through a mask, for example, a lith film.

On the other hand, although lithographic printing plate precursors which are subjected to the UV exposure through a mask, for example, a lith film and capable of undergoing on-press development have also been known, they do not form an image by the exposure with a semiconductor laser emitting an infrared ray and are insufficient in the printing durability (Patent Documents 3 to 5).

Further, in case of the UV exposure through a mask, for example, a lith film, when air is present between a PS

plate and a lith film, the printing durability deteriorated due to influence of oxygen and thus, it is necessary to conduct vacuuming (pressure reduction).

It is known that in order to increase an adhesion property of a lithographic printing plate precursor to a lith film at the vacuuming, a mat layer constructed from projections formed independently from each other is preferably provided on the image-recording layer.

As a method of forming the mat layer, for example, a method of spraying water containing a polymer and drying is known (Patent Document 6). Also, a method of adding a polymer fine particle, for example, polyethylene to the image-recording layer or an upper layer of the image-recording layer is known (Patent Document 7).

However, the first method has a problem in that since the image-recording layer in the lithographic printing plate precursor of on-press development type is relatively hydrophilic in comparison with that in the lithographic printing plate precursor of alkali development type, the mat solution penetrates into the image-recording layer. The second method is insufficient in the on-press development property and has a problem in that the polymer fine particles deposit on a dampening water roller, an ink roller or the like after the on-press development to be transferred onto a printed material.

As a lithographic printing plate precursor which solves these problems, a lithographic printing plate precursor containing a polymer having a polyoxyalkylene chain in its side chain in an image-recording layer thereof is known, but the lithographic printing plate precursor is insufficient in the printing durability both by the UV exposure and by the infrared ray exposure (Patent Document 8).

In Patent Document 9 a negative-working imageable element is described that has an imageable layer that includes an initiator composition including an iodonium cation and a borate anion, an infrared radiation absorbing compound, a particulate primary polymeric binder, and a phosphate (meth)acrylate adhesion promoter. The element also includes a polymeric overcoat disposed over the imageable layer and can be developed on-press to provide a lithographic printing plate with high run length. The element also has improved shelf-life.

Patent Document 10 provides a radiation-sensitive composition, which comprises a compound composed of at least one anion containing a phosphorus atom, an antimony atom, or an arsenic atom, and at least one cation selected from the group consisting of an organometallic cation, and an iodine, phosphorus, carbon, nitrogen, or sulfur-centered organic onium cation. There is also provided an ink composition using the same, an inkjet recording method, printed matter, a lithographic printing plate, and a method for manufacturing the lithographic printing plate.

Patent Document 11 provides a lithographic printing plate precursor which is excellent in the gum development property, running processing property and scratch resistance and a lithographic printing plate precursor which is good in all performances of the on-press development property, ink receptivity, sensitivity and printing durability, and a method of producing thereof. Further, it is provided a lithographic printing plate precursor comprising a support, an image-recording layer containing a radical polymerization initiator and a radical polymerizable compound, and an overcoat layer containing a polymer resin which has a cloud point in an aqueous solution and includes a monomer unit containing at least any of an amino group and an amido bond, in this order.

PRIOR ART DOCUMENT

PATENT DOCUMENT

Patent Document 1: JP-A-2001-277740

Patent Document 2: .IP-A-2001-277742

Patent Document 3: JP-A-2000-39711

Patent Document 4: JP-A-4-166934

Patent Document 5: JP-T-10-500915

Patent Document 6: JP-A-58-182636

Patent Document 7: JP-B-61-8421

Patent Document 8: U.S. Patent Publication No. 2003/0064318

Patent Document 9: WO 2008/156552 (A1)

Patent Document 10: JP 2007/224229 (A)

Patent Document 11: EP 2554395 (A1)

DISCLOSURE OF THE INVENTION

PROBLEMS THAT THE INVENTION IS TO SOLVE

The present invention has an object to provide a plate making method comprising conducting UV exposure of an on-press developable lithographic printing plate precursor which exhibits high printing durability by image exposure with a semiconductor laser emitting an infrared ray through a lith film and conducting on-press development, wherein the printing durability and on-press development property are good, deposition of scum hardly occurs at the on-press development, and the vacuum adhesion property to a lith film is good.

MEANS FOR SOLVING THE PROBLEMS

As a result of intensive investigations, the inventors have found that a lithographic printing plate precursor in which a cyanine dye is used as an infrared absorbing dye and a diphenyl iodonium salt or triphenyl iodonium salt is used as a polymerization initiator, and a polymer fine particle having a polyoxyalkylene chain in its side chain is introduced into an image-recording layer enables plate making of a lithographic printing plate having high printing durability by any of exposure with a semiconductor laser emitting an infrared ray and UV exposure through a lith film, exhibits good vacuum adhesion property to a lith film at the pressure reduction of UV exposure through the lith film, and exhibits good on-press development property to complete the present invention.
Specifically, the present invention includes the plate making method defined in claim 1 and the printing method defined in claim 8.

ADVANTAGE OF THE INVENTION

According to the present invention, in a plate making method comprising conducting exposure through a lith film and conducting on-press development, the printing durability and on-press development property become good, deposition of scum hardly occurs at the on-press development, and the vacuum adhesion property to a lith film becomes good.

MODE FOR CARRYING OUT THE INVENTION

«Lithographic printing plate precursor»

The lithographic printing plate precursor for use in the invention comprises a support and an image-recording layer in this order, and further comprises an oxygen-blocking layer thereon, if desired. Further, it may comprise an undercoat layer between the support and the image-recording layer in some cases.

[Image-recording layer]

The constituting components of the image-recording layer will be described in detail below.
The image-recording layer according to the invention is an image-recording layer capable of undergoing on-press development utilizing image formation by radical polymerization and contains a cyanine dye, a diphenyl iodonium salt or triphenyl sulfonium salt which may have a substituent on the phenyl group, a radical polymerizable compound and a polymer fine particle having a polyoxyalkylene chain in its side chain.
Each component which is incorporated into the image-recording layer is described in order below.

[Polymer fine particle having polyoxyalkylene chain in its side chain]

The polymer fine particle having a polyoxyalkylene chain in its side chain includes, for example, a latex obtained by radical polymerization and a microgel obtained by interfacial polymerization.
As to the polymer fine particle having a polyoxyalkylene chain in its side chain according to the invention (hereinafter, also simply referred to as a specific polymer compound), the average particle size thereof is preferably in

a range from 50 to 2,000 nm, more preferably in a range from 60 to 1,000 nm, and particularly preferably in a range from 70 to 300 nm.

The content of the specific polymer compound according to the invention is preferably in a range from 10 to 90% by weight, more preferably in a range from 10 to 80% by weight, particularly preferably in a range from 15 to 70% by weight, based on the total solid content of the image-recording layer. In the range described above, good on-press development property, vacuum adhesion property and printing durability can be obtained.

The oxyalkylene group which is a repeating unit of the polyoxyalkylene chain described above is preferably an oxyalkylene group having from 2 to 6 carbon atoms, and more preferably an oxyethylene group or an oxypropylene group. One polyoxyalkylene chain may contain both an oxyethylene group and an oxypropylene group. Of the oxyalkylene groups, an oxyethylene group is particularly preferred.

A number of repetitions of the oxyalkylene group in the polyalkylene oxide chain is preferably in a range from 10 to 120, more preferably in a range from 20 to 70, and particularly preferably in a range from 20 to 50.

In the range from 10 to 120 of the number of repetitions of the oxyalkylene group, good on-press development property and printing durability are obtained.

The microgel is more preferred than the latex obtained by radical polymerization from the standpoint of on-press development property.

(Microgel obtained by interfacial polymerization)

The microgel according to the invention can be produced by dissolving a polyfunctional isocyanate compound having two or more isocyanate groups in a water-immiscible solvent, emulsifying and dispersing the resulting solution in an aqueous solution containing a polyether derivative having a terminal amino group or hydroxy group represented by formula (I) shown below, and then removing the solvent from oil particles in the emulsion dispersion.

Alternatively, it can be produced by dissolving as at least one kind of isocyanate, an isocyanate compound which is a reaction product of a difunctional or higher functional isocyanate compound with a polyether derivative having a terminal amino group or hydroxy group represented by formula (I) shown below in a water-immiscible solvent, emulsifying and dispersing the resulting solution in an aqueous solution, and then removing the solvent from oil particles in the emulsion dispersion.

In the microgel, a polyurea or polyurethane/urea obtained by a polymerization reaction between the isocyanate compound and the polyether derivative having a terminal amino group or hydroxy group represented by formula (I) shown below constitutes the wall material.

Formula (I):

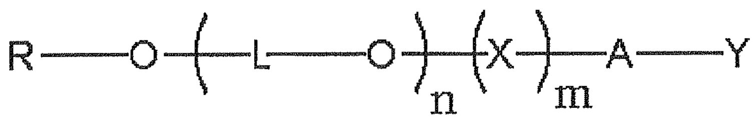

In formula (I), X represents a connecting group, A represents a single bond, an arylene group or an alkylene group, L represents an alkylene group having from 2 to 6 carbon atoms, R represents an organic group having no active hydrogen, Y represents -OH or $-NH_2$, m represents 0 or 1, and n indicates an average addition molar number of the polyether group and represents a number from 10 to 120.

Known methods can be applied to the operation. Specifically, an oil phase solution prepared by dissolving a polyfunctional isocyanate compound having two or more isocyanate functional groups, which is soluble in a water-immiscible solvent (which may contain a reaction product between (1) a difunctional or higher functional isocyanate compound and (2) a polyether derivative having a terminal amino group or hydroxy group represented by formula (I) shown above) in a water-immiscible solvent and an aqueous solution (which may contain a polyether derivative having a terminal amino group or hydroxy group represented by formula (I) shown above) are prepared and they are mixed and vigorously stirred and mixed using a emulsifying and dispersing machine, for example, a homogenizer, for example, at 12,000 rpm for from 10 to 15 minutes to emulsify and disperse oil droplets in the aqueous phase. Then, the resulting emulsion dispersion is heated and stirred to evaporate the solvent, whereby the desired aqueous dispersion of microgel particle is obtained.

The average particle size of the microgel is preferably in a range from 50 to 2,000 nm, more preferably in a range from 60 to 1,000 nm, and particularly preferably in a range from 70 to 300 nm.

[Polyfunctional isocyanate]

The polyfunctional isocyanate having two or more isocyanate groups will be described.

Specific examples of the compound include, for instance, as a difunctional compound having two isocyanate groups in its molecule, m-phenylene diisocyanate, p-phenylene diisocyanate, 2,6-tolylene diisocyanate, 2,4-tolylene diisocyanate, naphthalene-1,4-diisocyanate, diphenylmethane-4,4'-diisocyanate, 3,3'-dimethoxybiphenyl diisocyanate, 3,3'-dimethyldiphenylmethane-4,4'-diisocyanate, xylylene-1,4-diisocyanate, xylylene-1,3-diisocyanate, 4-chloroxylylene-1,3-diisocyanate, 2-methylxylylene-1,3-diisocyanate, 4,4'-diphenylpropane diisocyanate, 4,4'-diphenylhexafluoropropane diisocyanate, trimethylene diisocyanate, hexamethylene diisocyanate, propylene-1,2-diisocyanate, butylene-1,2-diisocyanate, cyclohexylene-1,2-diisocyanate, cyclohexylene-1,3-diisocyanate, cyclohexylene-1,4-diisocyanate, dicyclohexylmethane-4,4' -diisocyanate, 1,4-bis(isocyanatemethyl)cyclohexane, 1,3-bis(isocyanatemethyl)cyclohexane, isophorone diisocyanate and lysine diisocyanate.

Further, according to the invention, a trifunctional or higher functional isocyanate compound is utilized. Examples of the compound which can be used include a trimer (biuret or isocyanurate) of the difunctional isocyanate compound described above using the difunctional isocyanate compound as a main raw material, a polyfunctional compound as a adduct of the difunctional isocyanate compound with a polyol, for example, trimethylolpropane, a formalin condensate of benzene isocyanate, a polymer of a isocyanate compound having a polymerizable group, for example, methacryloyloxyethyl isocyanate, and lysine triisocyanate. In particular, a trimer (biuret or isocyanurate) of xylene diisocyanate or hydrogenation product thereof, hexamethylene diisocyanate, or tolylene diisocyanate or hydrogenation product thereof using the isocyanate compound as the main raw material and polyfunctional adducts of the isocyanate compounds described above with trimethylolpropane are preferred. These compounds are described in Polyurethane Jushi Handbook (Polyurethane Resin Handbook), edited by Keiji Iwata, published by The Nikkan Kogyo Shimbun, Ltd. (1987).

Among the compounds, 2,4-tolylene diisocyanate, 2,6-tolylene diisocyanate, xylylene-1,4-diisocyanate, xylylene-1,3-diisocyanate and an adduct of trimethylolpropane with xylylene-1,4-diisocyanate or xylylene-1,3-diisocyanate are preferred, and particularly, xylylene-1,4-diisocyanate, xylylene-1,3-diisocyanate and an adduct of trimethylolpropane with xylylene-1,4-diisocyanate or xylene-1,3-diisocyanate are preferred.

[Polyether derivative having terminal amino group or hydroxy group represented by formula (I)]

Next, the polyether derivative having a terminal amino group or hydroxy group represented by formula (I) will be described.

Formula (I):

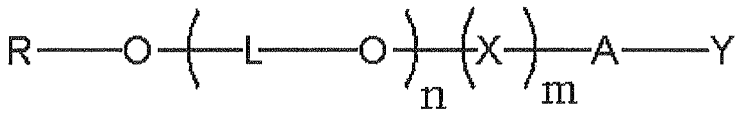

In formula (I), X represents a connecting group, A represents a single bond, an arylene group or an alkylene group, L represents an alkylene group having from 2 to 6 carbon atoms, R represents an organic group having no active hydrogen, Y represents -OH or $-NH_2$, m represents 0 or 1, and n indicates an average addition molar number of the polyether group and represents a number from 10 to 120.

R is preferably an alkyl group having from 1 to 3 carbon atoms, and particularly preferably a methyl group. L is preferably an ethylene group or a propylene group, and both an ethylene group and a propylene group may be present in one molecule. n is preferably from 20 to 70, and more preferably from 20 to 50. X is preferably an oxygen atom, and A is preferably a single bond.

The weight average molecular weight (Mw) of the polyether derivative is preferably from 300 to 100,000, and more preferably from 500 to 10,000. By controlling the weight average molecular weight in a range from 300 to 100,000, the polyether derivative sufficiently functions as a protective colloid to ensure dispersion stability of the microgel and to achieve sufficient hydrophilicity of the surface.

(Latex obtained by radical polymerization)

The polymer having a polyoxyalkylene chain in its side chain for use in the lithographic printing plate precursor according to the invention is preferably a resin obtained by radical polymerization of an ethylenically unsaturated group, for example, a (meth)acrylic resin, a vinyl resin, a styrene resin, an acrylonitrile resin or a polyvinyl acetal resin.

The polyalkylene oxide moiety is preferably contained as a side chain of the specific polymer compound, in the

form of structure represented by formula (1) shown below. More preferably, it is contained as a side chain of an acrylic resin, in the form of structure represented by formula (1) shown below.

Formula (1):

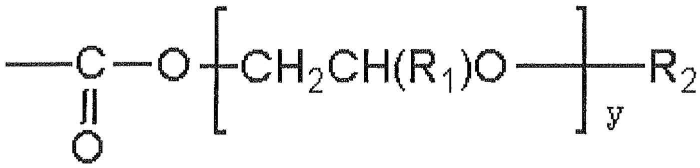

In formula (1), y represents an integer in a range from 10 to 120, preferably an integer in a range from 20 to 70, and more preferably an integer in a range from 20 to 50. $R_1$ represents a hydrogen atom or an alkyl group, preferably a hydrogen atom or a methyl group, and most preferably a hydrogen atom.

$R_2$ represents a hydrogen atom or an alkyl group having from 1 to 6 carbon atoms. The alkyl group having from 1 to 6 carbon atoms includes a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group and a cyclohexyl group.

Above all, $R_2$ is most preferably a hydrogen atom or a methyl group.

Specifically, the latex obtained by radical polymerization for use in the invention is preferably a polymer fine particle of a copolymer (hereinafter, also referred to as an ethylenically unsaturated copolymer) which contains a repeating unit of a structure having a polyalkylene group in an ester side chain of a (meth)acrylate represented by formula (3) shown below and is obtained by radical polymerization of an ethylenically unsaturated group.

Formula (3):

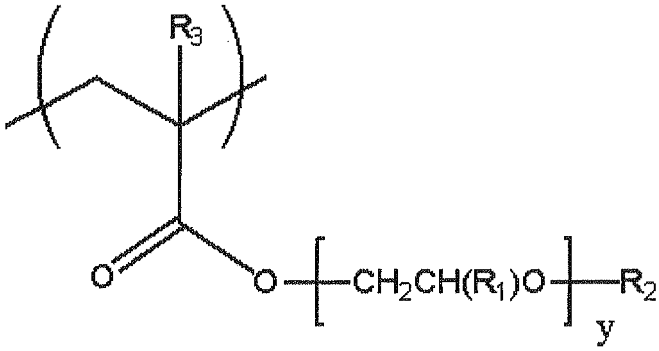

In formula (3), $R_3$ represents a hydrogen atom or a methyl group, and $R_1$, $R_2$ and y have the same meanings as $R_1$, $R_2$ and y in formula (1), respectively.

Specifically, the latex obtained by radical polymerization is preferably a polymer fine particle of the ethylenically unsaturated copolymer having a repeating unit having a structure represented by any one of formulae (3-1) to (3-4) shown below.

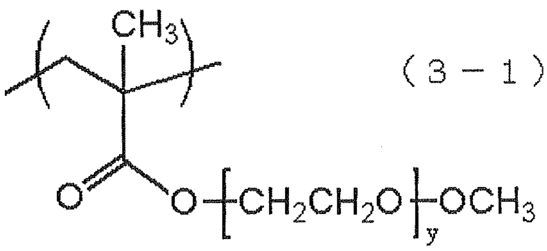

(3 − 1)

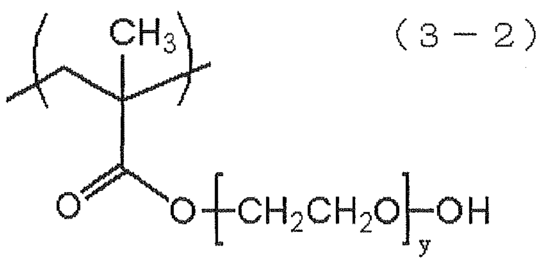

(3 − 2)

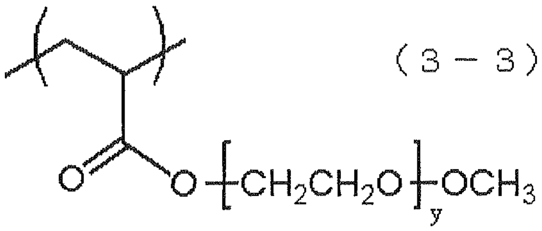

(3 − 3)

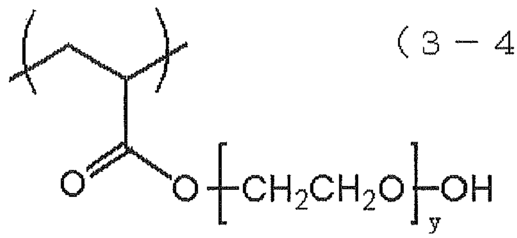

(3 − 4)

In the formulae above, y represents an integer from 10 to 120, preferably from 20 to 70, and more preferably from 20 to 50.

[Copolymerization monomer of ethylenically unsaturated copolymer]

The copolymerizable monomer for use in the invention is not particularly restricted and known or well known compounds having a carbon-carbon unsaturated double bond can be usefully employed.

Other monomers for use in the copolymer includes, known monomer, for example, an acrylate, a methacrylate, an acrylamide, a methacrylamide, a vinyl ester, a styrene or (meth)acrylonitrile. Specific examples of the acrylate include methyl acrylate, ethyl acrylate, (n- or iso-)propyl acrylate, (n-, iso-, sec- or tert-)butyl acrylate, amyl acrylate, 2-ethylhexyl acrylate, dodecyl acrylate, chloroethyl acrylate, 2-hydroxyethyl acrylate, 2-hydroxypropyl acrylate, 5-hydroxypentyl acrylate, cyclohexyl acrylate, allyl acrylate, trimethylolpropane monoacrylate, pentaerythritol monoacrylate, benzyl acrylate, methoxybenzyl acrylate, chlorobenzyl acrylate, hydroxybenzyl acrylate, hydroxyphenethyl acrylate, dihydroxyphenethyl acrylate, furfuryl acrylate, tetrahydrofurfuryl acrylate, phenyl acrylate, hydroxyphenyl acrylate, chlorophenyl acrylate, sulfamoylphenyl acrylate and 2-(hydroxyphenylcarbonyloxy)ethyl acrylate.

Specific examples of the methacrylate include methyl methacrylate, ethyl methacrylate, (nor iso-)propyl methacrylate, (n-, iso-, sec- or tert-)butyl methacrylate, amyl methacrylate, 2-ethylhexyl methacrylate, dodecyl methacrylate, chloroethyl methacrylate, 2-hydroxyethyl methacrylate, 2-hydroxypropyl methacrylate, 5-hydroxypentyl methacrylate, cyclohexyl methacrylate, allyl methacrylate, trimethylolpropane monomethacrylate, pentaerythritol monomethacrylate, glycidyl methacrylate, benzyl methacrylate, methoxybenzyl methacrylate, chlorobenzyl methacrylate, hydroxybenzyl methacrylate, hydroxyphenethyl methacrylate, dihydroxyphenethyl methacrylate, furfuryl methacrylate, tetrahydrofurfuryl methacrylate, phenyl methacrylate, hydroxyphenyl methacrylate, chlorophenyl methacrylate, sulfamoylphenyl methacrylate and 2-(hydroxyphenylcarbonyloxy)ethyl methacrylate.

Specific examples of the acrylamide include acrylamide, N-methylacrylamide, N-ethylacrylamide, N-propylacrylamide, N-butylacrylamide, N-benzylacrylamide, N-hydroxyethylacrylamide, N-phenylacrylamide, N-tolylacrylamide, N-(hydroxyphenyl)acrylamide, N-(sulfamoylphenyl)acrylamide, N-(phenylsulfonyl)acrylamide, N-(tolylsulfonyl)acrylamide, N,N-dimethylacrylamide, N-methyl-N-phenylacrylamide and N-hydroxyethyl-N-methylacrylamide.

Specific examples of the methacrylamide include methacrylamide, N-methylmethacrylamide, N-ethylmethacrylamide, N-propylmethacrylamide, N-butylmethacrylamide, N-benzylmethacrylamide, N-hydroxyethylmethacrylamide, N-phenylmethacrylamide, N-tolylmethacrylamide, N-(hydroxyphenyl)methacrylamide, N-(sulfamoylphenyl)methacrylamide, N-(phenylsulfonyl)methacrylamide, N-(tolylsulfonyl)methacrylamide, N,N-dimethylmethacrylamide, N-methyl-N-phenylmethacrylamide and N-hydroxyethyl-N-methylmethacrylamide.

Specific examples of the vinyl ester include vinyl acetate, vinyl butyrate and vinyl benzoate. Specific examples of the styrene include styrene, methylstyrene, dimethylstyrene, trimethylstyrene, ethylstyrene, propylstyrene, cyclohexylstyrene, chloromethylstyrene, trifluoromethylstyrene, ethoxymethylstyrene, acetoxymethylstyrene, methoxystyrene, dimethoxystyrene, chlorosyrene, dichlorostyrene, bromostyrene, iodostyrene, fluorostyrene and carboxystyrene.

Of the other monomers, an acrylate having 20 or less carbon atoms, a methacrylate, an acrylamide, a methacrylamide, a vinyl ester, a styrene and (meth)acrylonitrile are particularly preferably employed.

It is preferred from the standpoint of vacuum adhesion property of a lith film that a monomer which forms a homopolymer having Tg of 80°C or more is copolymerized as the copolymerizable ethylenically unsaturated monomer. In the case where (meth)acrylonitrile is contained in the polymer, acrylonitrile is preferably contained and the content thereof is preferably 50% by weight or more, more preferably 60% by weight or more, still preferably 70% by weight or more, and particularly preferably 80% by weight or more.

[Radical polymerizable group]

The specific polymer compound preferably has a radical polymerizable group in order to increase ink receptivity in the image area. It is believed that when the radical polymerizable group is present at the time of interaction which

occurs at the UV exposure for a long time between the polyoxyalkylene chain present as a side chain of the polymer fine particle and the polymerizable compound which is in a propagation step in the radical polymerization, it reacts with an ethylenically unsaturated group in the polymer fine particle existing in the neighborhood to fix the micro-structural change, whereby the ink receptivity is more improved.

In order to impart the crosslinking property to the polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amide residue (R in -COOR or -CONHR) has an ethylenically unsaturated bond.

Examples of the residue (R described above) having an ethylenically unsaturated bond include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R^3$ each represents a hydrogen atom, a halogen atom or an alkyl group having from 1 to 20 carbon atoms, an aryl group, alkoxy group or aryloxy group, or $R^1$ and $R^2$ or $R^1$ and $R^3$ may be combined with each other to form a ring. n represents an integer from 1 to 10. X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amide residue include $-CH_2CH=CH_2$, $-CH_2CH_2-Y$ (wherein Y represents a cyclohexene residue) and $-CH_2CH_2-OCO-CH=CH_2$.

The specific polymer compound having a crosslinkable property is cured, for example, by addition of a free radical (a polymerization initiating radical or a growing radical of a polymerizable compound in the process of polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

The content of the crosslinkable group (content of the radical polymerizable unsaturated double bond determined by iodine titration) in the specific polymer compound is preferably from 0.1 to 10.0 mmol, more preferably from 1.0 to 7.0 mmol, most preferably from 2.0 to 5.5 mmol, based on 1 g of the polymer compound. In the range described above, good sensitivity and good preservation stability can be obtained.

[Specific structure of polymer]

Specific structures of the specific polymer compound are set forth below, but the invention should not be construed as being limited thereto. The following (a), (b-1), (b-2), (c-1), (c-2) and (c-3) each indicates a structure of repeating unit used in Table 1.

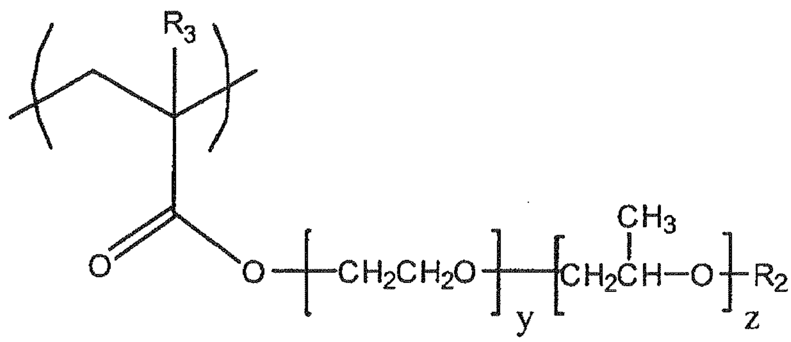

(a)

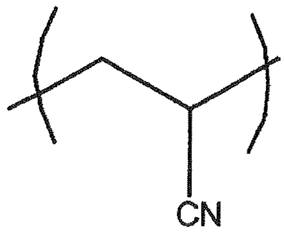

(b-1)

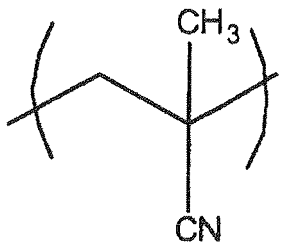

(b-2)

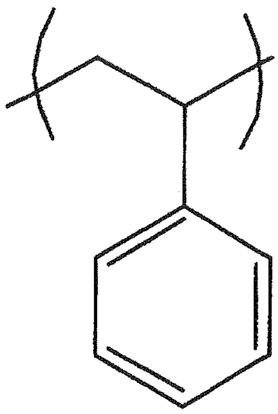

(c-1)

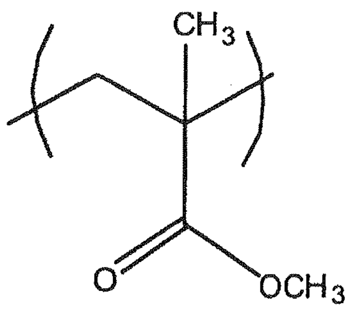

(C-2)

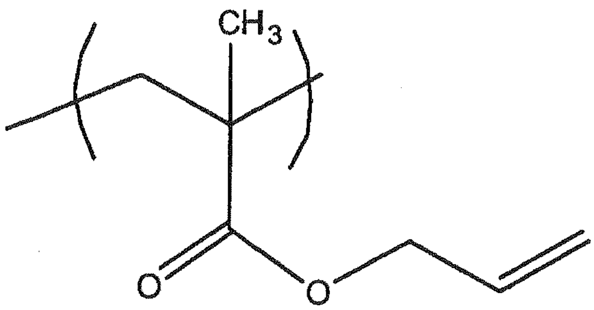

(C-3)

TABLE 1: Ratio of Repeating Unit in Specific Polymer Compounds No. 1 to No. 26

| Specific Polymer Compound No. | (a) | | | | | (b-1) | (b-2) | (c-1) | (c-2) | (c-3) |
|---|---|---|---|---|---|---|---|---|---|---|
| | y | z | $R_2$ | $R_3$ | Percent by Weight | Percent by Weight | Percent by Weight | Percent by Weight | Percent by Weight | Percent by Weight |
| 1 | 2 | 0 | $-CH_3$ | $-CH_3$ | 10 | 70 | 0 | 20 | 0 | 0 |

(continued)

| Specific Polymer Compound No. | (a) | | | | | (b-1) | (b-2) | (c-1) | (c-2) | (c-3) |
|---|---|---|---|---|---|---|---|---|---|---|
| | y | z | $R_2$ | $R_3$ | Percent by Weight | Percent by Weight | Percent by Weight | Percent by Weight | Percent by Weight | Percent by Weight |
| 2 | 4 | 0 | $-CH_3$ | $-CH_3$ | 10 | 70 | 0 | 20 | 0 | 0 |
| 3 | 10 | 0 | $-CH_3$ | $-CH_3$ | 10 | 70 | 0 | 20 | 0 | 0 |
| 4 | 40 | 0 | $-CH_3$ | $-CH_3$ | 10 | 70 | 0 | 20 | 0 | 0 |
| 5 | 90 | 0 | $-CH_3$ | $-CH_3$ | 10 | 70 | 0 | 20 | 0 | 0 |
| 6 | 120 | 0 | $-CH_3$ | $-CH_3$ | 10 | 70 | 0 | 20 | 0 | 0 |
| 7 | 200 | 0 | $-CH_3$ | $-CH_3$ | 10 | 70 | 0 | 20 | 0 | 0 |
| 8 | 0 | 10 | $-CH_3$ | $-CH_3$ | 10 | 70 | 0 | 20 | 0 | 0 |
| 9 | 0 | 40 | $-CH_3$ | $-CH_3$ | 10 | 70 | 0 | 20 | 0 | 0 |
| 10 | 0 | 120 | $-CH_3$ | $-CH_3$ | 10 | 70 | 0 | 20 | 0 | 0 |
| 11 | 0 | 200 | $-CH_3$ | $-CH_3$ | 10 | 70 | 0 | 20 | 0 | 0 |
| 12 | 10 | 10 | $-CH_3$ | $-CH_3$ | 10 | 70 | 0 | 20 | 0 | 0 |
| 13 | 40 | 40 | $-CH_3$ | $-CH_3$ | 10 | 70 | 0 | 20 | 0 | 0 |
| 14 | 10 | 0 | $-CH_3$ | $-CH_3$ | 10 | 70 | 0 | 20 | 0 | 0 |
| 15 | 40 | 0 | $-CH_3$ | $-CH_3$ | 10 | 70 | 0 | 20 | 0 | 0 |
| 16 | 120 | 0 | $-CH_3$ | $-CH_3$ | 10 | 70 | 0 | 20 | 0 | 0 |
| 17 | 10 | 0 | $-CH_3$ | $-CH_3$ | 10 | 70 | 0 | 20 | 0 | 0 |
| 18 | 40 | 0 | $-CH_3$ | $-CH_3$ | 10 | 70 | 0 | 20 | 0 | 0 |
| 19 | 120 | 0 | $-CH_3$ | $-CH_3$ | 10 | 70 | 0 | 20 | 0 | 0 |
| 20 | 40 | 0 | $-CH_3$ | $-CH_3$ | 5 | 75 | 0 | 20 | 0 | 0 |
| 21 | 40 | 0 | $-CH_3$ | $-CH_3$ | 20 | 70 | 0 | 10 | 0 | 0 |
| 22 | 40 | 0 | $-CH_3$ | $-CH_3$ | 30 | 70 | 0 | 0 | 0 | 0 |
| 23 | 40 | 0 | $-CH_3$ | $-CH_3$ | 10 | 0 | 70 | 20 | 0 | 0 |
| 24 | 40 | 0 | $-CH_3$ | $-CH_3$ | 10 | 70 | 0 | 0 | 20 | 0 |
| 25 | 40 | 0 | $-CH_3$ | $-CH_3$ | 10 | 70 | 0 | 10 | 0 | 10 |
| 26 | 40 | 0 | $-CH_3$ | $-CH_3$ | 10 | 70 | 0 | 0 | 10 | 10 |

[Cyanine dye]

The cyanine dye which absorbs an infrared ray has a function of converting the infrared ray absorbed to heat and a function of being excited by the infrared ray to perform electron transfer and/or energy transfer to a radical polymerizable compound described hereinafter. The cyanine dye for use in the invention is a dye having an absorption maximum in a wavelength range from 760 to 1,200 nm.

As a particularly preferred example thereof, a cyanine dye represented by formula (a) shown below is exemplified.

Formula (a):

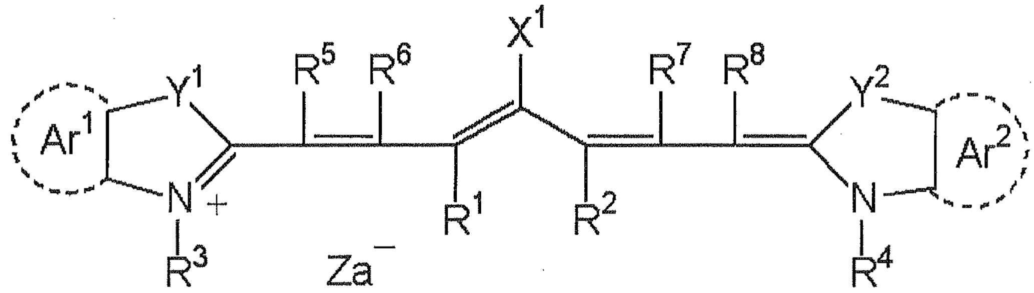

In formula (a), $X^1$ represents a hydrogen atom, a halogen atom, $-N(R^9)(R^{10})$, $-X^2-L^1$ or a group shown below. $R^9$ and $R^{10}$, which may be the same or different, each represents an aryl group having from 6 to 10 carbon atoms which may have a ubstituent, an alkyl group having from 1 to 8 carbon atoms or a hydrogen atom, or $R^9$ and $R^{10}$ may be combined with each other to form a ring. Among them, a phenyl group is preferred ($-NPh_2$). $X^2$ represents an oxygen atom or a sulfur atom, $L^1$ represents a hydrocarbon group having from 1 to 12 carbon atoms, a heteroaryl group or a hydrocarbon group having from 1 to 12 carbon atoms and containing a hetero atom. The hetero atom used herein indicates N, S, O, a halogen atom or Se. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

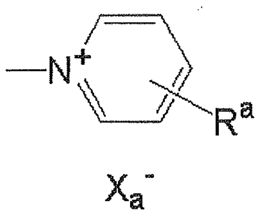

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. Also, $R^1$ and $R^2$ may be combined with each other to form a ring and when $R^1$ and $R^2$ form the ring, it is particularly preferred to form a 5-membered or 6-membered ring.

$Ar^1$ and $Ar^2$, which may be the same or different, each represents an aryl group which may have a substituent. Preferred examples of the aryl group include a benzene ring and a naphthalene ring. Also, preferred examples of the substituent include a hydrocarbon group having 12 or less carbon atoms, a halogen atom, an alkoxy group having 12 or less carbon atoms and a sulfo group. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferred examples of the substituent include an alkoxy group having 12 or less carbon atoms, a carboxyl group, an oxycarbonyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferred examples of $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion.

In formula (a), more preferably, $X^1$ represents $-NPh_2$, $R^1$ and $R^2$ are combined with each other to form a 5-membered ring, $Ar^1$ and $Ar^2$ each represents the same benzene ring or naphthalene ring, which may have a substituent, wherein examples of preferred substituent include a methyl group, a chlorine atom, a methoxy group and a sulfo group, $Y^1$ and $Y^2$ each represents the same dimethylmethylene group, and $R^3$ and $R^4$ each represents the same hydrocarbon group having 5 or less carbon atoms, which may have a substituent, wherein examples of preferred substituent include an alkoxy group having 3 or less carbon atoms and an oxycarbonyl group.

Specific examples of the cyanine dye represented by formula (a), which can be preferably used in the invention, include compounds described in Paragraph Nos. [0017] to [0019] of JP-A-2001-133969, compounds described in Paragraph Nos. [0012] to [0037] of JP-A-2002-40638, compounds described in Paragraph Nos. [0034] to [0041] of JP-A-2002-278057 and Paragraph Nos. [0080] to [0086] of JP-A-2008-195018, and compounds described in Paragraph Nos.

[0035] to [0043] of JP-A-2007-90850.

Specifically, cyanine dyes having a structure set forth below are exemplified.

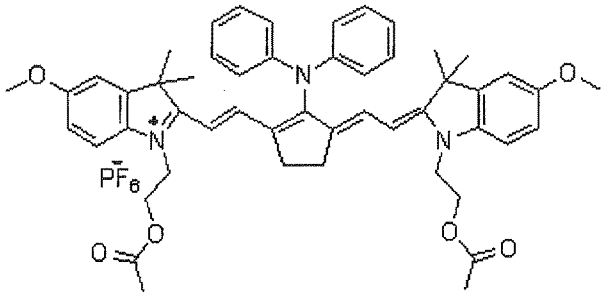

A-1

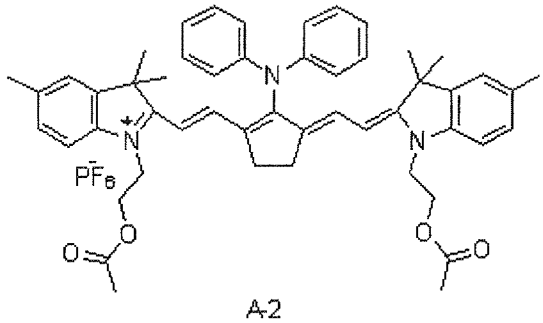

A-2

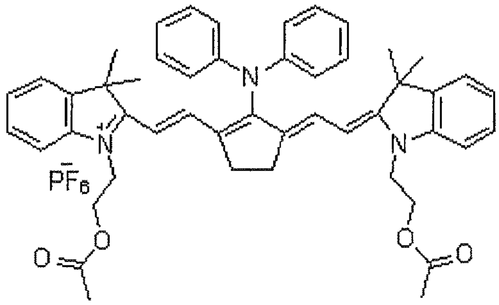

A-3

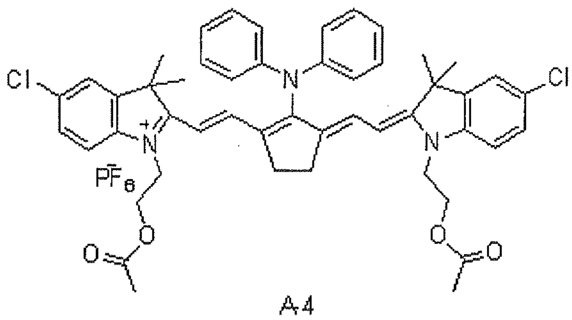

A-4

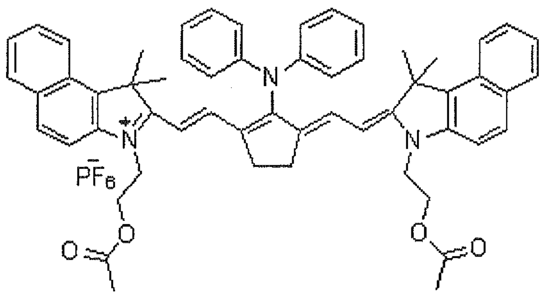

A-5

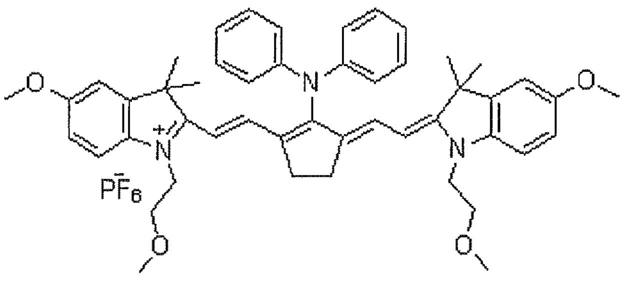

A-6

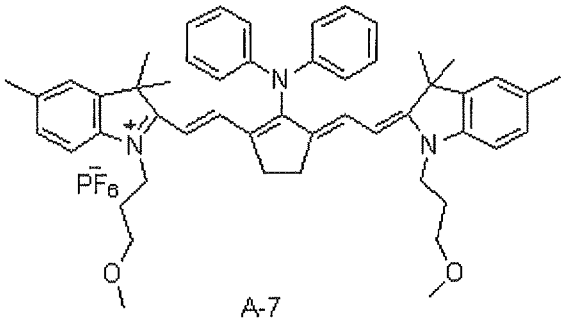

A-7

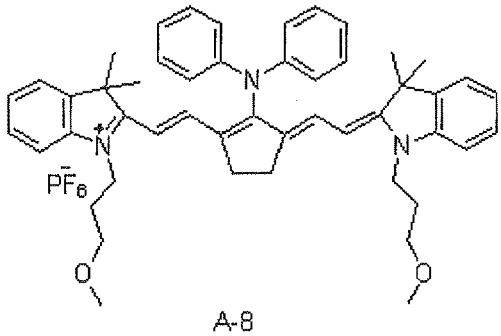

A-8

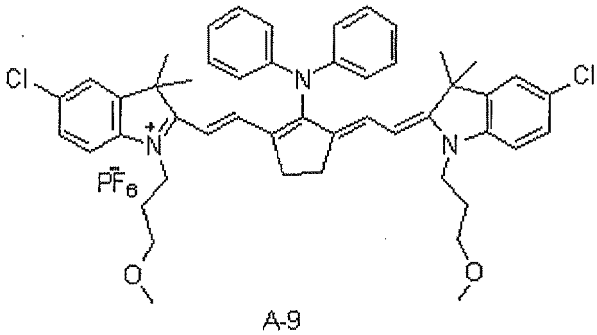

A-9

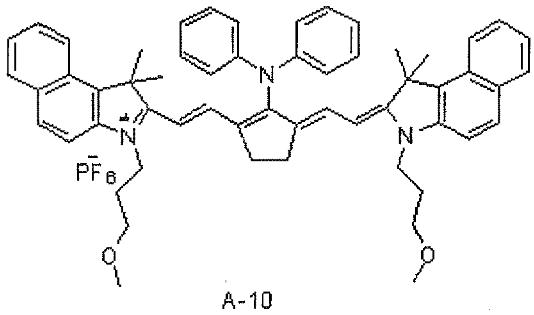

A-10

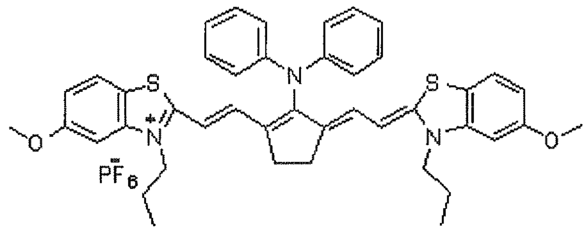

A-11

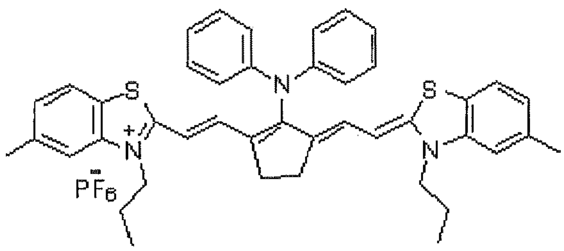

A-12

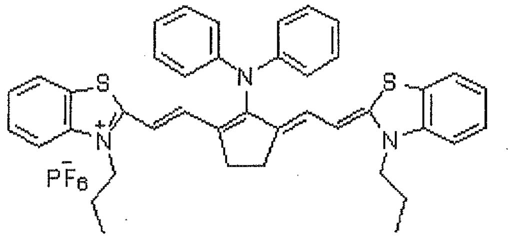

A-13

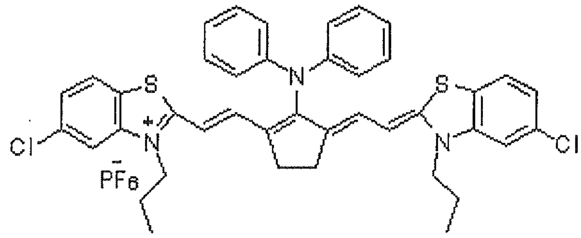

A-14

23

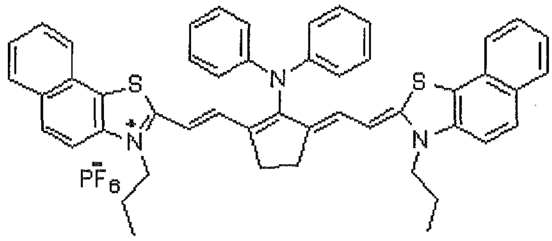

A-15

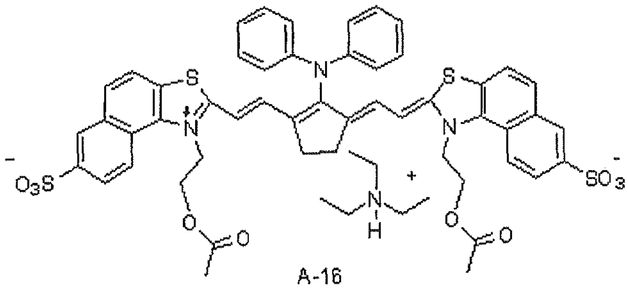

A-16

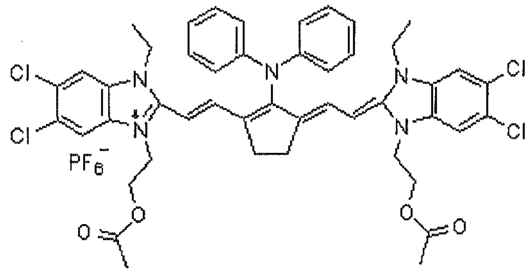

A-17

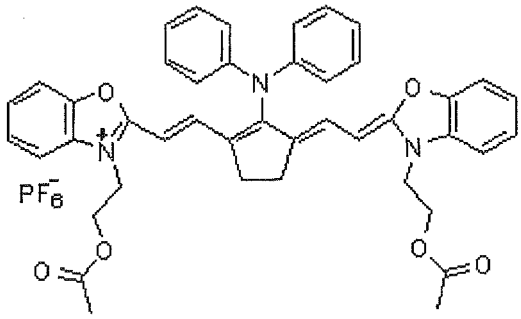

A-18

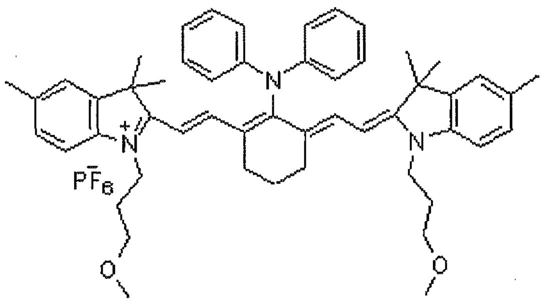

A-19

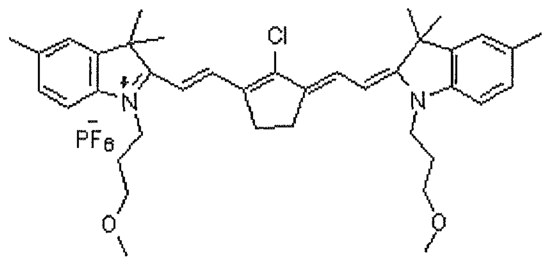

A-20

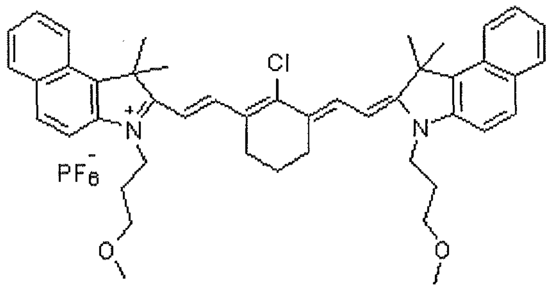

A-21

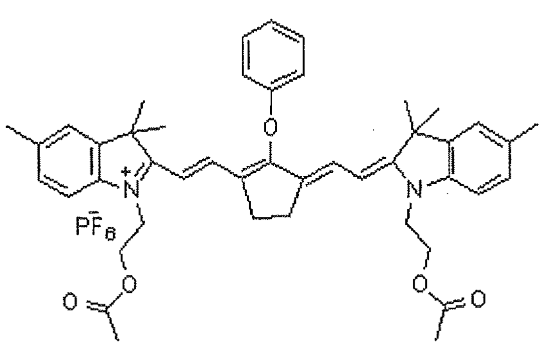

A-22

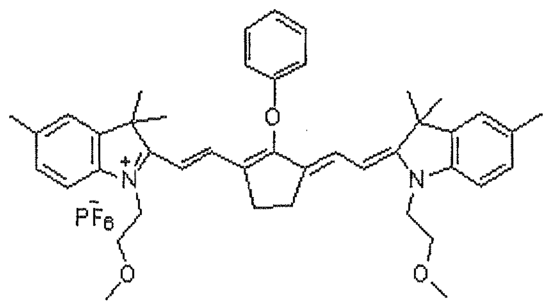

A-23

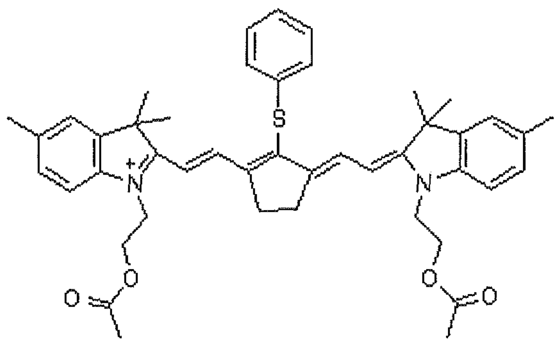

A-24

The content of the cyanine dye in the image-recording layer according to the invention is preferably from 0.1 to 10.0% by weight, more preferably from 0.5 to 5.0% by weight, based on the total solid content of the image-recording layer.

[Diphenyl iodonium salt or triphenyl sulfonium salt]

The diphenyl iodonium salt or triphenyl sulfonium salt for use in the invention is a compound which initiates or accelerates polymerization of a radical polymerizable compound (D).
The diphenyl iodonium salt includes, for example, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977).
The triphenyl sulfonium salt includes, for example, sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581. Specific examples of the compound are set forth below, but the invention should not be construed as being limited thereto.
The diphenyl iodonium salt may have a substituent on the phenyl group, and in particular, a diphenyl iodonium salt substituted with an electron donating group, for example, an alkyl group or an alkoxy group is preferred, and an asymmetric diphenyliodonium salt is more preferred.
Specific examples thereof include diphenyl iodonium hexafluorophosphate, 4-methoxyphenyl-4-(2-methylpropyl)phenyl iodonium hexafluorophosphate, 4-(2-methylpropyl)phenyl-p-tolyl iodonium hexafluorophosphate, 4-hexyloxyphenyl-2,4,6-trimethoxyphenyl iodonium hexafluorophosphate, 4-hexyloxyphenyl-2,4-diethoxyphenyl iodonium tetrafluoroborate, 4-octyloxyphenyl-2,4,6-trimethoxyphenyl iodonium 1-perfluorobutanesulfonate, 4-octyloxyphenyl-2,4,6-trimethoxyphenyl iodonium hexafluorophosphate and bis(4-tert-butylphenyl) iodonium tetraphenylborate.
The triphenyl sulfonium salt may have a substituent on the phenyl group, and in particular, a triphenyl sulfonium having a halogen atom on the phenyl group is preferred.
Examples of the triphenyl sulfonium salt include triphenyl sulfonium hexafluorophosphate, triphenyl sulfonium benzoylformate, bis(4-chlorophenyl)phenyl sulfonium benzoylformate, bis(4-chlorophenyl)-4-methylphenyl sulfonium tetrafluoroborate, tris(4-chlorophenyl) sulfonium 3,5-bis(methoxycarbonyl)benzenesulfonate and tris(4-chlorophenyl) sulfonium hexafluorophosphate.
The diphenyl iodonium salt or triphenyl sulfonium salt can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the printing are obtained.

[Radical polymerizable compound]

The radical polymerizable compound for use in the image-recording layer according to the invention is an addition-polymerizable compound having at least one ethylenically unsaturated double bond and it is selected from compounds having at least one, preferably two or more, terminal ethylenically unsaturated bonds. The radical polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.
Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R^4)COOCH_2CH(R^5)OH \qquad (A)$$

(wherein $R^4$ and $R^5$ each independently represents H or $CH_3$.)

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethylene oxide-modified acrylate, for example, tris(acryloyloxyethyl) isocyanurate or bis(acryloyloxyethyl)hydroxyethyl isocyanurate is particularly preferred, because it is excellent in balance between hydrophilicity relating to the on-press development property and polymerization ability relating to the printing durability.

Details of the method of using the polymerizable compound, for example, the structure thereof, individual or combination use or the amount thereof added, can be appropriately determined in accordance with the characteristic design of the final lithographic printing plate precursor. The polymerizable compound is used preferably in a range from 5 to 75% by weight, more preferably in a range from 5 to 70% by weight, particularly preferably in a range from 10 to 60% by weight, based on the total solid content of the image-recording layer.

[Binder polymer]

In the image-recording layer according to the invention, a binder polymer can be used for the purpose of improving film strength of the image-recording layer. The binder polymer which can be used in the invention can be selected from those heretofore known without restriction, and polymers having a film-forming property are preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable group and the hydrophilic group makes it possible to maintain compatibility between the printing durability and development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferred. In particular, a polyethylene oxide structure containing from 2 to 8 ethylene oxide units is preferred. In order to introduce a hydrophilic group into the binder polymer, a monomer having the hydrophilic group is copolymerized.

In order to control the ink receptivity, an oleophilic group, for example, an alkyl group, an aryl group, an aralkyl group or an alkenyl group may be introduced into the binder polymer according to the invention. Specifically, an oleophilic

group-containing monomer, for example, an alkyl methacrylate is copolymerized.

Specific examples (1) to (11) of the binder polymer for use in the invention are set forth below, but the invention should not be construed as being limited thereto. The ratio of the repeating units is indicated as a molar ratio.

(1)

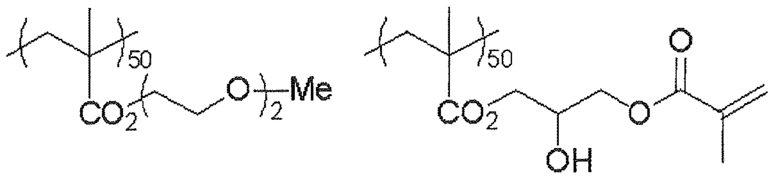

(2)

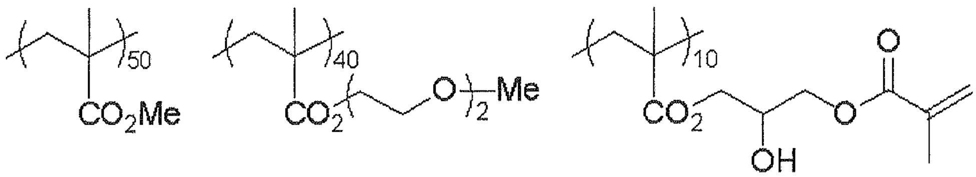

(3)

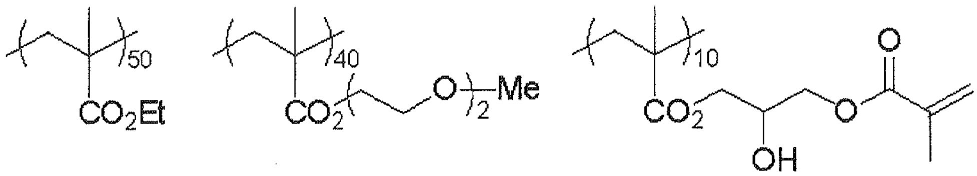

(4)

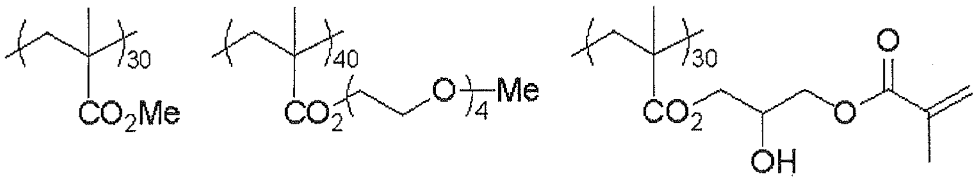

(5)

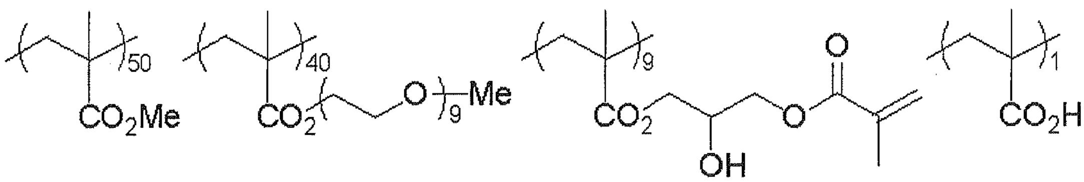

(6)

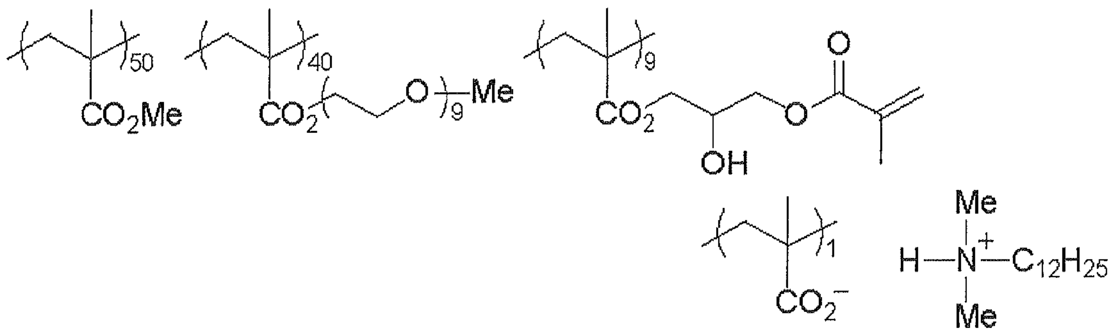

(7)

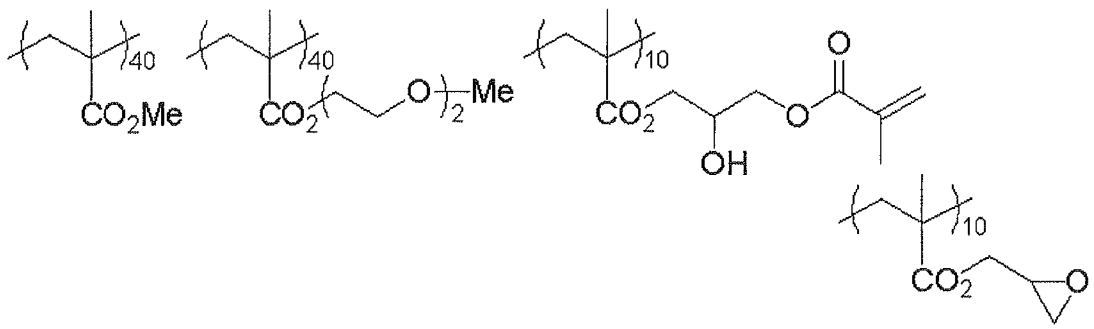

(8)

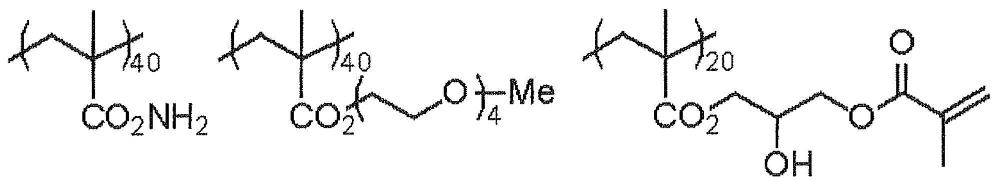

(9)

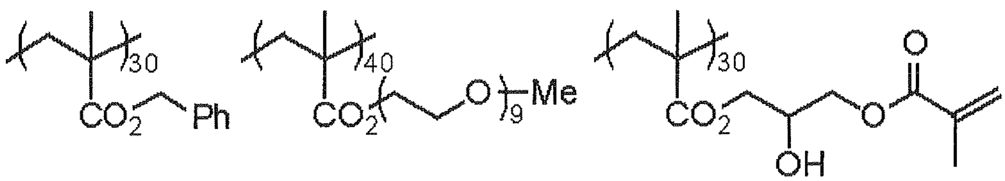

(10)

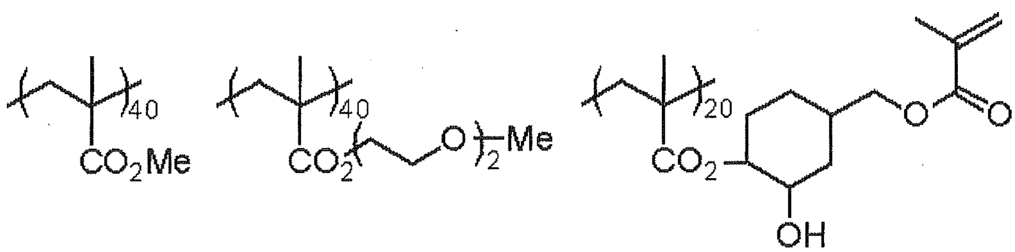

(11)

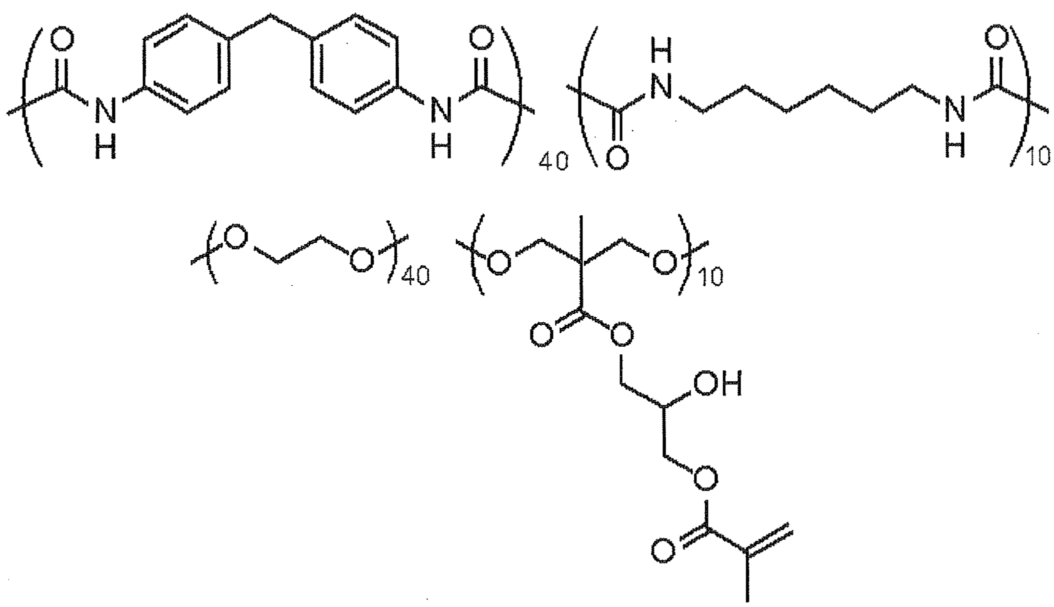

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily from 5 to 90% by weight, preferably from 5 to 80% by weight, more preferably from 10 to 70% by weight, based on the total solid content of the image-recording layer.

[Other components]

The image-recording layer according to the invention may further contain other components, if desired.

(1) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerine, pentaerythritol or tris(2-hydroxyethyl) isocyanurate, an organic amine, e.g., triethanol amine, diethanol amine monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetradecosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt

or a lithium salt.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 10% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an oxygen-blocking layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate, 1,9-bis(triphenylphosphonio)nonane naphthalene-2,7-disulfonate and 1,9-bis(triphenylphosphonio)nonane di(hexafluorophosphate).

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

The ammonium group-containing polymer may be any polymer containing an ammonium group in its structure and is preferably a polymer containing from 5 to 80% by mole of (meth)acrylate having an ammonium group in its side chain as a copolymerization component.

As to the ammonium salt-containing polymer, its reduced specific viscosity value (unit: cSt/g/ml) determined according to the measuring method described below is preferably from 5 to 120, more preferably from 10 to 110, particularly preferably from 15 to 100.

<Measuring method of reduced specific viscosity>

In a 20 ml measuring flask was weighed 3.33 g of a 30% by weight polymer solution (1 g as a solid content) and the measuring flask was filled up to the gauge line with N-methyl pyrrolidone. The resulting solution was put into an Ubbelohde viscometer (viscometer constant: 0.010 cSt/s) and a period for running down of the solution at 30°C was measured. The viscosity was determined in a conventional manner according to the following calculating formula:

$$\text{Kinetic viscosity} = \text{Viscometer constant x Period for liquid to pass through a capillary (sec)}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90)

(2) 2-(Trimethylammonio)ethyl methacrylate hexafluorophosphate /3,6-dioxaheptyl methacrylate copolymer (molar ratio: 20/80)

(3) 2-(Ethyldimethylammonio)ethyl methacrylate p-toluenesulfonate/hexyl methacrylate copolymer (molar ratio: 30/70)

(4) 2-(Trimethylammonio)ethyl methacrylate hexafluorophosphate /2-ethylhexyl methacrylate copolymer (molar ratio: 20/80)

(5) 2-(Trimethylammonio)ethyl methacrylate methylsulfate/hexyl methacrylate copolymer (molar ratio: 40/60)

(6) 2-(Butyldimethylammonio)ethyl methacrylate hexafluorophosphate/3,6-dioxaheptyl methacrylate copolymer (molar ratio: 20/80)

(7) 2-(Butyldimethylammonio)ethyl acrylate hexafluorophosphate/3,6-dioxaheptyl methacrylate copolymer (molar ratio: 20/80)

(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80)

(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(3) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

[Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 $g/m^2$. In the range described above, good sensitivity and good film property of the image-recording layer can be achieved.

[Oxygen-blocking layer]

The lithographic printing plate precursor for use in the invention preferably has an oxygen-blocking layer. The oxygen-blocking layer preferably contains a water-soluble resin and at lest one selected from a polymer fine particle having a polyoxyalkylene chain in its side chain, an inorganic spherical fine particle and an inorganic stratiform fine particle. By incorporating the fine particle also into the oxygen-blocking layer, the vacuum adhesion property of a lith film is more improved in comparison with the case where the fine particle is incorporated into the image-recording layer. In the case of adding the fine particle, it is needed to incorporate a water-soluble resin in order to bind the fine particles.

[Water-soluble resin]

The water-soluble resin for binding the fine particles is not particularly restricted as long as it can well disperse the fine particles and can form a uniform layer adhering to the image-recording layer, and can be appropriately selected to use. Specifically, for example, polyvinyl alcohol, a modified polyvinyl alcohol, polyvinyl pyrrolidone, polyvinyl imidazole, polyacrylic acid, polyacrylamide, a partially saponified product of polyvinyl acetate, an ethylene-vinyl alcohol copolymer, a water-soluble cellulose derivative, gelatin, a starch derivative or gum arabic is exemplified. The water-soluble resins may be used in combination of two or more thereof, if desired. Of the resins, polyvinyl alcohol, a modified polyvinyl alcohol, polyvinyl pyrrolidone, gelatin or gum arabic is more preferred from the standpoint that it is able to be coated using water as a solvent and that it is easily removed with dampening water at the printing.

The polyvinyl alcohol for use in the oxygen-blocking layer according to the invention may be partially substituted with an ester, an ether or an acetal as long as it contains a substantial amount of unsubstituted vinyl alcohol units necessary for maintaining water solubility. Also, the polyvinyl alcohol may partially contain other copolymerization components. Specific examples of the polyvinyl alcohol include those being hydrolyzed 71 to 100% by mole and having a

polymerization degree in a range from 300 to 2,400.

Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd. are exemplified. As the copolymer described above, polyvinyl acetate chloroacetate or propionate, polyvinyl formal and polyvinyl acetal and copolymers thereof each hydrolyzed from 88 to 100% by mole are exemplified.

Also, a known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer chain a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified. From the standpoint of on-press development property, polyvinyl alcohol having an anion-modified cite is preferred, and polyvinyl alcohol modified with an anion of sulfo group is particularly preferred.

As to the modified polyvinyl alcohol according to the invention, a commercially available product may be used. Examples of the commercially available product include KURARAY POVAL KM-118, KL-118, KL-318, KL-506 and KM-618 (produced by Kuraray Co., Ltd.), GOSENAL T and GOSERAN L-3266 (produced by Nippon Synthetic Chemical Industry Co., Ltd.). Two or more kinds of modified polyvinyl alcohols may be used in combination.

[Fine particle]

By providing the oxygen-blocking layer containing the fine particle on the image-recording layer, the printing durability is more improved as well as the vacuum adhesion property is more improved. The fine particle is at least one selected from a polymer fine particle having a polyoxyalkylene chain in its side chain, an inorganic spherical fine particle and an inorganic stratiform fine particle. In case of the polymer fine particle, a polymer fine particle having a polyoxyalkylene chain in its side chain is preferred from the standpoint of preventing the deposition of scum at the on-press development.

The content of the total fine particle component contained in the oxygen-blocking layer is preferably from 0.1 to 80% by weight, more preferably from 1 to 50% by weight, and still more preferably from 5 to 30% by weight. The content of the fine particle in the oxygen-blocking layer is preferably from 5/1 to 1/100 in terms of weight ratio relative to the amount of the water-soluble resin used in the oxygen-blocking layer. When a plurality of the fine particles is used in combination, it is also preferred that the total amount of the fine particles fulfill the above-described weight ratio.

[Polymer fine particle having polyoxyalkylene chain in its side chain]

The polymer fine particle having a polyoxyalkylene chain in its side chain for use in the oxygen-blocking layer is same as the polymer fine particle for use in the image-recording layer described above.

[Inorganic spherical fine particle]

The inorganic spherical fine particle includes, for example, metal and a metal compound, for example, an oxide, a compound oxide, a hydroxide, a carbonate, a sulfate, a silicate, a phosphate, a nitride, a carbide, a sulfide or a composite compound of two or more thereof. Specific examples thereof include glass, zinc oxide, silica, alumina, zirconium oxide, tin oxide, potassium titanate, strontium titanate, aluminum borate, magnesium oxide, magnesium borate, aluminum hydroxide, magnesium hydroxide, calcium hydroxide, titanium hydroxide, basic magnesium sulfate, calcium carbonate, magnesium carbonate, calcium sulfate, magnesium sulfate, calcium silicate, magnesium silicate, calcium phosphate, silicon nitride, titanium nitride, aluminum nitride, silicon carbide, titanium carbide, zinc sulfide and composite compounds of two or more thereof. Preferred examples thereof include glass, silica, alumina, potassium titanate, strontium titanate, aluminum borate, magnesium oxide, calcium carbonate, magnesium carbonate, calcium silicate, magnesium silicate, calcium phosphate and calcium sulfate.

As the filler, commercially available products may be used. For instance, silica filler includes, for example, SNOWTEX 50 (particle size: 0.025 μm), SNOWTEX O-40 (particle size: 0.025 μm), SNOWTEX CM (particle size: 0.025 μm), SNOWTEX 20L (particle size: 0.045 μm), SNOWTEX XL (particle size: 0.05 μm), SNOWTEX YL (particle size: 0. 65 μm), SNOWTEX ZL (particle size: 0.85 μm), MP 1040 (particle size: 0.1 μm), MP 2040 (particle size: 0.2 μm), MP 3040 (particle size: 0.3 μm), MP 1040 (particle size: 0.1 μm) and MP 4540M (particle size [silica]: 0.45 μm) produced by Nissan Chemical Industries, Ltd., and SYLYSIA 310 (particle size: 1.4 μm), SYLYSIA 320 (particle size: 1.6 μm),

SYLYSIA 350 (particle size: 1.8 μm), SYLYSIA 370 (particle size: 3.0 μm), SYLYSIA 530 (particle size: 1.9 μm), SYLYSIA 550 (particle size: 2.7 μm), SYLYSIA 250 (particle size: 2.7 μm) and SYLYSIA 430 (particle size: 2.5 μm) produced by Fuji Silysia Chemical Ltd.

In the inorganic spherical fine particle, it is particularly preferred that the inorganic component is silica ($SiO_2$) from the standpoint of dispersion stability in a coating solution, cost and high friction coefficient.

As to the size of the inorganic spherical fine particle, an average particle size is preferably in a range from 50 to 2,000 nm, more preferably in a range from 60 to 1,000 nm, and particularly preferably in a range from 70 to 300 nm. When the average particle size is 50 nm or more, the vacuum adhesion property is more improved. When the average particle size is 2,000 nm or less, since the oxygen-blocking property is sufficient, the image-forming sensitivity does not decrease, and since the contact area of the inorganic spherical fine particle is sufficient, the effect of increasing the friction coefficient is sufficiently obtained not to cause the displacement.

The average particle size described above was measured according to a centrifugal sedimentation method using a particle size distribution measurement device (BI-DCP, produced by Brookhaven Instruments Corp.)

[Inorganic stratiform compound]

According to the invention, the oxygen-blocking layer may contain an inorganic stratiform compound together with the water-soluble resin. The inorganic stratiform compound is a particle having a thin tabular shape and includes, for instance, mica, for example, natural mica represented by the following formula: $A\,(B,\,C)_{2\text{-}5}\,D_4\,O_{10}\,(OH,\,F,\,O)_2$ (wherein A represents any of K, Na and Ca, B and C each represents any of Fe (II), Fe(III), Mn, Al, Mg and V, and D represents Si or Al) or synthetic mica, talc represented by the following formula: $3MgO{\cdot}4SiO{\cdot}H_2O$, taeniolite, montmorillonite, saponite, hectorite and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilicic mica $KMg_{2.5}(Si_4O_{10})F_2$, and swellable mica, for example, Na tetrasilicic mica $NaMg_{2.5}(Si_4O_{10})F_2$, Na or Li taeniolite $(Na, Li)Mg_2Li(Si_4O_{10})F_2$, or montmorillonite-based Na or Li hectorite $(Na, Li)_{1/8}Mg_{2/5}Li_{1/8}(Si_4O_{10})F_2$. Synthetic smectite is also useful.

In the invention, of the inorganic stratiform compounds, mica is preferred and fluorine-based swellable mica, which is a synthetic inorganic stratiform compound, is particularly useful. Specifically, the swellable synthetic mica and a swellable clay mineral, for example, montmorillonite, saponite, hectorite or bentonite have a laminate structure comprising a unit crystal lattice layer having thickness of approximately from 10 to 15 angstroms, and metallic atom substitution in the lattices thereof is remarkably large in comparison with other clay minerals. As a result, the lattice layer results in lack of positive charge and to compensate it, a cation, for example, $Li^+$, $Na^+$, $Ca^{2+}$ or $Mg^{2+}$ is adsorbed between the lattice layers. Particularly, in the case where the cation between the layers is $Li^+$ or $Na^+$, since the ionic radius is small, the bond between the stratiform crystal lattices is weak, thereby greatly swelling with water. When share is applied under such a condition, the stratiform crystal lattices are easily cleaved to form a stable sol in water. The bentonite and swellable synthetic mica strongly show this tendency and are useful in the invention and in particular, the swellable synthetic mica is preferably used.

As to the shape of the inorganic stratiform compound for use in the invention, from the standpoint of control of diffusion, the thickness is preferably smaller and as long as the smoothness of the coated surface and the transmission of actinic radiation are not impaired, the plane size is preferably larger. Therefore, an aspect ratio is preferably 20 or more, more preferably 100 or more, and particularly preferably 200 or more. The aspect ratio is a ratio of major axis to thickness of particle and can be determined, for example, from a projection drawing of particle by a microphotography. As the aspect ratio is larger, the effect obtained is higher.

As to a particle diameter of the inorganic stratiform compound for use in the invention, an average major axis is from 0.3 to 20 μm, preferably from 0.5 to 10 μm, and particularly preferably from 1 to 5 μm. Also, an average thickness of the particle is 0.1 μm or less, preferably 0.05 μm or less, and particularly preferably 0.01 μm or less. For example, with respect to the swellable synthetic mica that is the representative compound of the inorganic stratiform compound, the thickness is approximately from 1 to 50 nm and the plain size is approximately from 1 to 20 μm.

When such an inorganic stratiform compound particle having a large aspect ratio is incorporated into the oxygen-blocking layer, strength of the coated layer increases and penetration of oxygen or moisture can be effectively inhibited and thus, the oxygen-blocking layer can be prevented from deterioration, for example, due to deformation, and even when the lithographic printing plate precursor is preserved for a long period of time under a high humidity condition, deterioration of the image-forming property in the lithographic printing plate precursor due to the change of humidity is prevented and the excellent preservation stability is obtained.

[Undercoat layer]

In the lithographic printing plate precursor according to the invention, it is preferred to provide an undercoat layer between the image-recording layer and the support. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As a compound for use in the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified. A polymer resin having an adsorbing group capable of adsorbing to a surface of the support, a hydrophilic group and a crosslinkable group as described in JP-A-2005-125749 and JP-A-2006-188038 is more preferably exemplified. The polymer resin is preferably a copolymer of a monomer having an adsorbing group, a monomer having a hydrophilic group and a monomer having a crosslinkable group. More specifically, a polymer resin which is a copolymer of a monomer having an adsorbing group, for example, a phenolic hydroxy group, a carboxyl group, $-PO_3H_2$, $-OPO_3H_2$, $-CONHSO_2-$, $-SO_2NHSO_2-$ and $-COCH_2COCH_3$, a monomer having a hydrophilic sulfo group and a monomer having a polymerizable crosslinkable group, for example, a methacryl group or an allyl group. The polymer resin may contain a crosslinkable group introduced by a salt formation between a polar substituent of the polymer resin and a compound containing a substituent having a counter charge to the polar substituent of the polymer resin and an ethylenically unsaturated bond and also may be further copolymerized with a monomer other than those described above, preferably a hydrophilic monomer.

The content of the unsaturated double bond in the polymer resin for undercoat layer is preferably from 0.1 to 10.0 mmol, most preferably from 2.0 to 5.5 mmol, based on 1 g of the polymer resin.

The weight average molecular weight of the polymer resin for undercoat layer is preferably 5,000 or more, more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with the surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compounds for the undercoat layer described above in order to prevent the occurrence of stain due to the lapse of time.

The undercoat layer is coated according to a known method. The coating amount (solid content) of the undercoat layer is preferably from 0.1 to 100 $mg/m^2$, and more preferably from 1 to 30 $mg/m^2$.

[Support]

As the support for use in the lithographic printing plate precursor according to the invention, a known support is employed. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu$m.

The support may have a backcoat layer containing an organic polymer compound described in JP-A-5-45885 or an alkoxy compound of silicon described in JP-A-6-35174, provided on the back surface thereof, if desired.

<<UV exposure/Transparent base material/Pressure reduction>>

For the ultraviolet ray, a flatbed exposure machine which can be used for exposure of a conventional PS plate wherein the image exposure is conducted through a lith film is preferably utilized. At this time, the vacuuming is conducted according to a standard equipment of the flatbed exposure machine. Specifically, a lithographic printing plate precursor is placed on an exposure table and a lith film is place of the lithographic printing plate precursor. Further, a transparent base material, for example, glass or a transparent film is placed on the lith film, the vacuuming is conducted, and the UV exposure is conducted, for example, with a halogen lamp or a mercury lamp. The degree of vacuum is preferably 100 mmHg or less, and particularly preferably 30 mmHg or less. This is because oxygen in the air causes polymerization

inhibition in the case of the image-recording layer in which an image is formed by radical polymerization By providing the oxygen-blocking layer, the polymerization inhibition due to oxygen in the air is prevented to achieve high printing durability.

«Plate making method/Printing method of lithographic printing plate»

Plate making of the lithographic printing plate precursor according to the invention is performed by an on-press development method. The on-press development method includes a step in which the lithographic printing plate precursor is imagewise exposed and a printing step in which at least any of oily ink and an aqueous component is supplied to the exposed lithographic printing plate precursor without undergoing any development processing to perform printing, and it is characterized in that the unexposed area of the lithographic printing plate precursor is removed in the course of the printing step. The imagewise exposure may be performed with an infrared semiconductor laser of high output or with UV exposure by a high-pressure mercury lamp or a metal halide lamp after placing a lith film and conducting vacuuming. After the exposure, the exposed lithographic printing plate precursor is mounted as it is on a printing machine without undergoing a development processing step. Then, the printing is conducted using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

EXAMPLE

The present invention will be described in detail with reference to the following examples, but the invention should not be construed as being limited thereto. With respect to polymer compound, unless otherwise specified, a molecular weight of the polymer compound means a weight average molecular weight (Mw) and a ratio of repeating units is indicated as a mole percent.

Example 1

[Preparation of Lithographic printing plate precursor (1)]

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 μm, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized film of 2.5 g/m$^2$, washed with water and dried to prepare Support (1).

Thereafter, in order to ensure the hydrophilicity of the non-image area, Support (1) was subjected to silicate

treatment using a 2.5% by weight aqueous sodium silicate No. 3 solution at 60°C for 10 seconds and then was washed with water to obtain Support (2). The adhesion amount of Si was 10 mg/$m^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) described above so as to have a dry coating amount of 20 mg/$m^2$ to prepare a support having an undercoat layer for using in the experiments described below.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

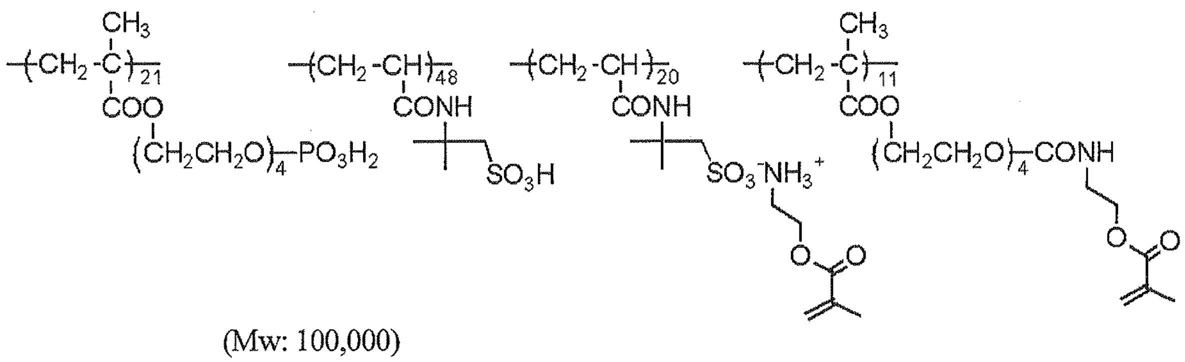

(Mw: 100,000)

Compound (1) for undercoat layer

(3) Formation of Image-recording layer

Coating solution for image-recording layer having the composition shown below was coated on the undercoat layer formed as described above by a bar and dried in an oven at 100°C for 60 seconds to form an image-recording layer having a dry coating amount of 1.0 g/$m^2$.

The coating solution for image-recording layer was prepared by mixing a pre-coating solution for image-recording layer shown below with an aqueous dispersion of polymer fine particle shown below just before the coating, followed by stirring.

<Pre-coating solution for image-recording layer>

| | |
|---|---|
| Binder polymer (1) having structure shown below | 0.240 g |
| Cyanine dye (Compound (A-7)) | 0.030 g |
| Radical polymerization initiator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |

(continued)

| | |
|---|---|
| Oil-sensitizing agent (Benzyl dimethyl octyl ammonium $PF_6$ salt | 0.018 g |
| Oil-sensitizing agent (Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

<Aqueous dispersion of polymer fine particle>

After adjusting the solid content concentration to 11.3% by weight by adding water to Microgel (1) described below, 5.06 g of the aqueous dispersion was added to the pre-coating solution for image-recording layer described above to prepare a coating solution for image-recording layer

The structures of Binder polymer (1), Radical polymerization initiator (1), Phosphonium compound (1), Hydrophilic low molecular weight compound (1), Ammonium group-containing polymer and Fluorine-based surfactant (1) are shown below.

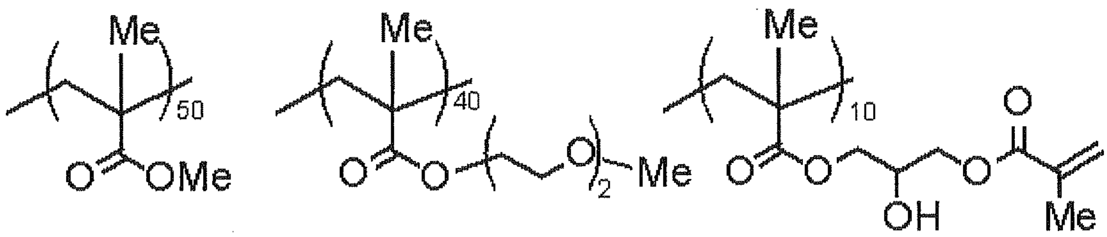

(Mw: 70,000)

Binder polymer (1)

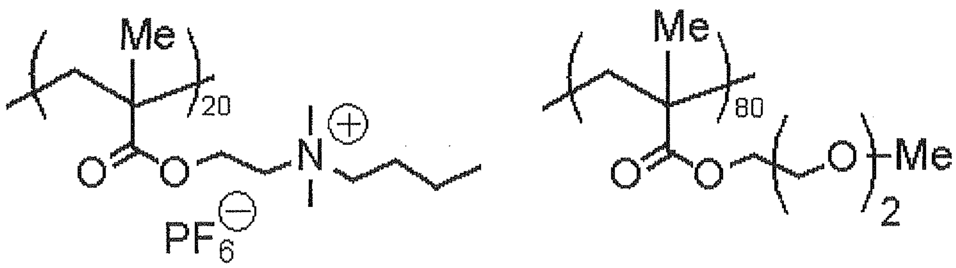

Ammonium group-containing polymer

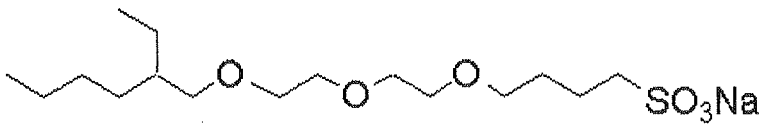

Hydrophilic low molecular weight compound (1)

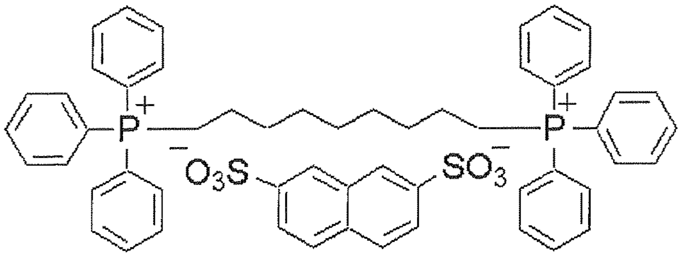

Phosphonium compound (1)

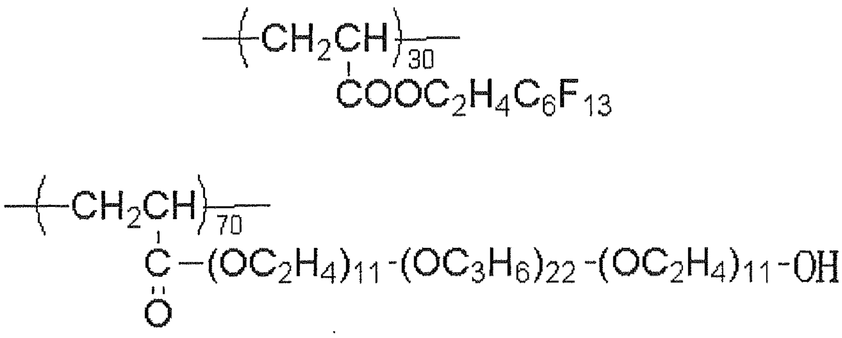

(Mw: 13,000)

Fluorine-based surfactant (1)

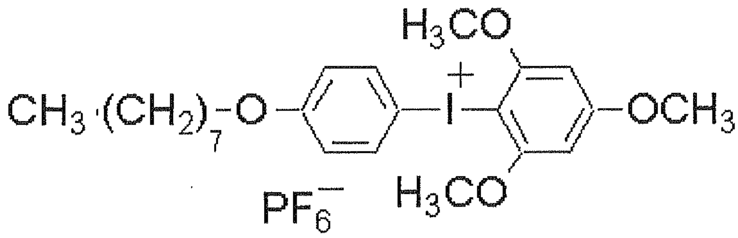

Radical polymerization initiator (1)

-Preparation of Microgel (1) (having polyoxyalkylene chain in its side chain)-

An oil phase component was prepared by dissolving 4.46 g of polyfunctional isocyanate having the structure shown below (produced by Mitsui Chemicals Polyurethane, Inc., 75% by weight ethyl acetate solution), 0.86 g of an adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals Polyurethane, Inc., 50% by weight ethyl acetate solution), 1.72 g of pentaerythritol tetraacrylate (SR399E, produced by Sartomer Co.) and 0.05 g of PIONIN A-41C (produced by Takemoto Oil & Fat Co., Ltd., 70% by weight methanol solution) in 4.46 g of ethyl acetate. The oil phase component and 17.30 g of water as an aqueous phase component were mixed and emulsified using a homogenizer at 10,000 rpm for 15 minutes. The resulting emulsion was stirred at 40°C for 4 hours. The microgel liquid thus-obtained was diluted using water so as to have the solid content concentration of 21.8% by weight. The average particle size of the microgel was 0.25 μm.

Polyfunctional isocyanate

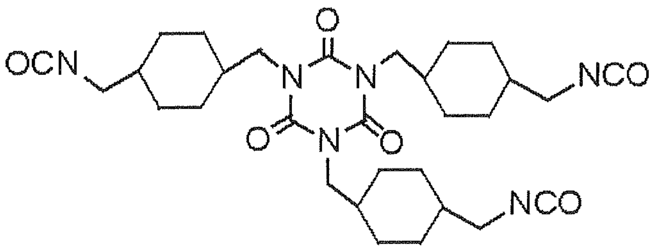

Examples 2 to 10 and Comparative Examples 1 to 3

Lithographic printing plate precursors (2) to (13) were prepared by replacing Cyanine dye (A-7) and Radical polymerization initiator (1) used in Example 1 with those as shown in Table 2, respectively.

Table 2

| Lithographic Printing Plate Precursor | Cyanine Dye | Polymerization Initiator |
|---|---|---|
| (2) | (A-7) | (2) |
| (3) | (A-7) | (3) |
| (4) | (A-7) | (4) |
| (5) | (A-19) | (1) |
| (6) | (A-20) | (1) |
| (7) | (A-16) | (4) |
| (8) | (A-16) | (1) |
| (9) | (A-7) | (A) |
| (10) | (A-16) | (A) |
| (11) | (A) | (1) |
| (12) | (A) | (4) |
| (13) | (A) | (A) |

Cyanine dye A:

2-[2-[2-Phenylthio-3-[(1,3-dihydro-1,3,3,-trimethyl-2H-indol-2-ilidene)ethylidene]-1-cyclo hexene-1-yl]ethenyl]-1,3,3-trimethyl-3H-indolium salt compound

Polymerization initiator (2):

Tris(4-chlorophenyl)sulfonium hexafluorophosphate

Polymerization initiator (3):

Chlorodiphenyl iodonium

Polymerization initiator (4):

Triphenylsulfonium hexafluorophosphate

Polymerization initiator (A):

2-(4-Methoxyphenyl)-4,6-bis(trichloromethyl)-2-triazine

[Exposure of Lithographic printing plate precursor]

(1) UX exposure

On the lithographic printing plate precursor (1,080 mm x 800 mm) obtained was placed a lith film (900 mm x 600 mm) and after conducting pressure reduction at the degree of vacuum of 25 mm Hg for 30 seconds, exposure was conducted for 30 seconds by PS Light.

(2) Exposure with infrared semiconductor laser

The lithographic printing plate precursor obtained was exposed by LLTXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

[Evaluation of Lithographic printing plate precursor]

(1) On-press development property and attachment of scum

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and FUSION-G (N) Black Ink (produced by DIC Corp.), the dampening water and ink were supplied according to the standard automatic printing start method of LITHRONE 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property.

Further, this operation was repeated 20 times using the exposed lithographic printing plate precursor and attachment of scum on a printed material obtained from the 20th plate was examined. The results obtained are shown in Table 3.

(2) Printing durability

After performing the evaluation for the on-press development property described above, the printing was further continued. As the increase in a number of printing papers, the image-recording layer was gradually abraded to cause decrease in the ink density on the printed material. A number of printing papers wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 3.

(3) Vacuum adhesion time

The lithographic printing plate precursor of 1,080 mm x 800 mm was placed on an exposure table of PS Light exposure machine, a lith film of 900 mm x 600 mm was placed on the lithographic printing plate precursor, and they were covered with a glass plate of PS Light and subjected to vacuuming at 25 mmHg. At that time, vacuum adhesion time was determined. The vacuum adhesion time was determined by measuring time necessary for removing air remaining between the lithographic printing plate precursor and the lith film. The results obtained are shown in Table 3.

TABLE 3

| | Lithographic Printing Plate Precursor | Number of Sheets of On-press Development | Printing Durability with UV Exposure | Printing Durability with Infrared Ray Exposure | Vacuum Adhesion Time (seconds) | Attachment of Scum |
|---|---|---|---|---|---|---|
| Example 1 | (1) | 10 | $5.0 \times 10^4$ sheets | $4.0 \times 10^4$ sheets | 25 | Absence |

(continued)

| | Lithographic Printing Plate Precursor | Number of Sheets of On-press Development | Printing Durability with UV Exposure | Printing Durability with Infrared Ray Exposure | Vacuum Adhesion Time (seconds) | Attachment of Scum |
|---|---|---|---|---|---|---|
| Example 2 | (2) | 10 | $4.5 \times 10^4$ sheets | $3.5 \times 10^4$ sheets | 25 | Absence |
| Example 3 | (3) | 10 | $4.0 \times 10^4$ sheets | $3.0 \times 10^4$ sheets | 25 | Absence |
| Example 4 | (4) | 10 | $4.0 \times 10^4$ sheets | $3.0 \times 10^4$ sheets | 25 | Absence |
| Example 5 | (5) | 10 | $4.5 \times 10^4$ sheets | $3.0 \times 10^4$ sheets | 25 | Absence |
| Example 6 | (6) | 10 | $4.5 \times 10^4$ sheets | $3.0 \times 10^4$ sheets | 25 | Absence |
| Example 7 | (7) | 10 | $4.5 \times 10^4$ sheets | $3.5 \times 10^4$ sheets | 25 | Absence |
| Example 8 | (8) | 10 | $5.0 \times 10^4$ sheets | $4.0 \times 10^4$ sheets | 25 | Absence |
| Example 9 | (11) | 12 | $4.0 \times 10^4$ sheets | $3.0 \times 10^4$ sheets | 25 | Absence |
| Example 10 | (12) | 12 | $4.0 \times 10^4$ sheets | $3.0 \times 10^4$ sheets | 25 | Absence |
| Comparative Example 1 | (9) | 10 | $1.5 \times 10^4$ sheets | $1.0 \times 10^4$ sheets | 25 | Absence |
| Comparative Example 2 | (10) | 10 | $1.5 \times 10^4$ sheets | $1.0 \times 10^4$ sheets | 25 | Absence |
| Comparative Example 3 | (13) | 12 | $1.5 \times 10^4$ sheets | $0.5 \times 10^4$ sheets | 25 | Absence |

In the case where the polymerization initiator which is combined with the cyanine dye is the diphenyl iodonium salt or triphenyl sulfonium salt, high printing durability is obtained both with the UV exposure and with infrared laser exposure.

Examples 11 to 22 and Comparative Examples 4 to 10

(1) Formation of Image-recording layer

With respect to Lithographic printing plate precursors (14) to (17) and (26) to (28), the image-recording layer was formed in the same manner as in Example 1 except for replacing Microgel (1) in the aqueous dispersion of polymer fine particle with microgel or polymer fine particle described below as shown in Table 4. The aqueous dispersion of polymer fine particle was used by adjusting the fine particle concentration to 11.3% by weight.

-Preparation of Microgel (2) (having polyoxyalkylene chain in its side chain and having ethylenically unsaturated bond)-

An oil phase component was prepared by dissolving 4.46 g of polyfunctional isocyanate having the structure shown above (produced by Mitsui Chemicals Polyurethane, Inc., 75% by weight ethyl acetate solution), 0.86 g of an adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals Polyurethane, Inc., 50% by weight ethyl acetate solution), 0.5 g of 2-methacryloyloxyethyl isocyanate (KARENZ MOI, produced by Showa Denko K. K.) and 0.05 g of PIONIN A-41C (produced by Takemoto Oil & Fat Co., Ltd., 70% by weight

methanol solution) in 4.46 g of ethyl acetate. The oil phase component and 17.30 g of water as an aqueous phase component were mixed and emulsified using a homogenizer at 10,000 rpm for 15 minutes. The resulting emulsion was stirred at 40°C for 4 hours. The microgel liquid thus-obtained was diluted using water so as to have the solid content concentration of 21.8% by weight. The average particle size of the microgel was 0.25 μm.

-Preparation of Microgel (3) (having no polyoxyalkylene chain in its side chain)-

An oil phase component was prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of polyvinyl alcohol (KURARAY POVAL PVA-205, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (3). The average particle size of the microgel was measured by a light scattering method and found to be 0.2 μm.

-Production of Polymer fine particle (1) (having polyoxyalkylene chain in its side chain and containing acrylonitrile)-

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

-Production of Polymer fine particle (2) (having polyoxyalkylene chain in its side chain and containing no acrylonitrile)-

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 90 g of methyl methacrylate (MMA) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (2) of polymer fine particle of PEGMA/MMA (10/90 in a weight ratio). The particle size distribution of the polymer fine particle had the maximum value at the particle size of 150 nm.

-Production of Polymer fine particle (3) (having polyoxyalkylene chain in its side chain and having ethylenically unsaturated group)-

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 10 g of allyl methacrylate (AllylMA), 200 g of distilled water and 200 g of n-propanol were charged therein and heated until the internal temperature

reached 70°C. Then, a mixture of 10 g of styrene (St), 70 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (3) of polymer fine particle of PEGMA/AllylMA/AN/St (10/10/70/10 in a weight ratio). The particle size distribution of the polymer fine particle had the maximum value at the particle size of 150 nm.

-Production of Polymer fine particle (4) (having no polyoxyalkylene chain in its side chain)-

To a reaction system, 15.0 g of methyl methacrylate and 100 ml of an aqueous polyoxyethylene phenol solution (concentration: 9.8 x $10^{-3}$ mol/liter) were added, and while stirring at 250 rpm, the inside of the system was purged with nitrogen gas. The resulting solution was adjusted to 25°C and 10 ml of an aqueous cerium(IV) ammonium salt solution (concentration: 0.984 x $10^{-3}$ mol/liter) was added thereto. At that time, an aqueous ammonium nitrate solution (concentration: 58.8 x $10^{-3}$ mol/liter) was added to adjust the pH to 1.3 to 1.4. Thereafter, the solution was stirred for 8 hours. The thus-obtained solution had solid content concentration of 13.0% by weight and an average particle size of 0.2 $\mu$m.

(2) Formation of Oxygen-blocking layer

With respect to Lithographic printing plate precursors (18) and (22), an oxygen-blocking layer was formed by coating a coating solution for oxygen-blocking layer prepared as described below.

With respect to Lithographic printing plate precursors (19) to (21), (23) to (25) and (29) to (32), an oxygen-blocking layer was formed by coating a coating solution for oxygen-blocking layer prepared by further adding the aqueous dispersion of fine particle shown in Table 4 to the coating solution for oxygen-blocking layer for forming Lithographic printing plate precursor (18). The aqueous dispersion of polymer fine particle was used by adjusting the fine particle concentration to 3.2% by weight.

A coating solution for oxygen-blocking layer having the composition shown below was coated on the image-recording layer described above by a bar and dried in an oven at 120°C for 60 seconds to form an oxygen-blocking layer having a dry coating amount of 0.15 g/$m^2$, thereby preparing each lithographic printing plate precursor.

<Coating solution for oxygen-blocking layer (containing no fine particle)>

| | |
|---|---|
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5% by mole, polymerization degree: 500, produced by Kuraray Co., Ltd.) | 0.30 g |
| Aqueous 1% by weight solution of surfactant (EMALEX 710, produced by Nihon Emulsion Co., Ltd.) | 0.86 g |
| Ion-exchanged water | 6.0 g |

<Coating solution for oxygen-blocking layer (containing fine particle)>

| | |
|---|---|
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5% by mole, polymerization degree: 500, produced by Kuraray Co., Ltd.) | 0.30 g |
| Aqueous 1% by weight solution of surfactant (EMALEX 710, produced by Nihon Emulsion Co., Ltd.) | 0.86 g |
| Ion-exchanged water | 6.0 g |
| Aqueous dispersion of fine particle (adjusting fine particle concentration to 3.2% by weight | 1.5 g |

(Preparation of Dispersion (1) of inorganic stratiform compound)

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the inorganic particle thus-dispersed was 100 or more.

(Preparation of Dispersion (1) of inorganic spherical fine particle)

To 393.6 g of ion-exchanged water was added 6.4 g of silica fine particle having an average particle size of 450 nm (SNOWTEX MP 4540M, produced by Nissan Chemical Industries, Ltd., solid content concentration: 40% by weight) and the mixture was dispersed.

TABLE 4: Fine Particles in Image-recording Layer and Oxygen-blocking Layer

| | Lithographic Printing Plate Precursor | Image-recording Layer | Oxygen-blocking layer | |
|---|---|---|---|---|
| | | Kind of Fine Particle | Presence or Absence of Layer | Kind of Fine Particle |
| Example 1 | (1) | Microgel (1) | - | - |
| Example 11 | (14) | Microgel (2) | - | - |
| Example 12 | (15) | Polymer Fine Particle (1) | - | - |
| Example 13 | (16) | Polymer Fine Particle (2) | - | - |
| Example 14 | (17) | Polymer Fine Particle (3) | - | - |
| Example 15 | (18) | Microgel (1) | Presence | - |
| Example 16 | (19) | Microgel (1) | Presence | Microgel (1) |
| Example 17 | (20) | Microgel (1) | Presence | Inorganic Stratiform Compound (1) |
| Example 18 | (21) | Microgel (1) | Presence | Inorganic Spherical Fine Particle (1) |
| Example 19 | (22) | Polymer Fine Particle (1) | Presence | - |
| Example 20 | (23) | Polymer Fine Particle (1) | Presence | Polymer Fine Particle (1) |
| Example 21 | (24) | Polymer Fine Particle (1) | Presence | Inorganic Stratiform Compound (1) |
| Example 22 | (25) | Polymer Fine Particle (1) | Presence | Inorganic Spherical Fine Particle (1) |
| Comparative Example 4 | (26) | - | - | - |
| Comparative Example 5 | (27) | Microgel (3) | - | - |
| Comparative Example 6 | (28) | Polymer Fine Particle (4) | - | - |
| Comparative Example 7 | (29) | - | Presence | Microgel (1) |

(continued)

| | Lithographic Printing Plate Precursor | Image-recording Layer | Oxygen-blocking layer | |
|---|---|---|---|---|
| | | Kind of Fine Particle | Presence or Absence of Layer | Kind of Fine Particle |
| Comparative Example 8 | (30) | - | Presence | Polymer Fine Particle (1) |
| Comparative Example 9 | (31) | - | Presence | Inorganic Stratiform Compound (1) |
| Comparative Example 10 | (32) | - | Presence | Inorganic Spherical Fine Particle (1) |

(3) Evaluation of Lithographic printing plate precursor

The exposure was conducted in the same manner as in Example 1 and the evaluation of lithographic printing plate precursor was conducted. The results obtained are shown in Table 5.

TABLE 5

| | Lithographic Printing Plate Precursor | Number of Sheets of On-press Development | Printing Durability with UV Exposure | Printing Durability with Infrared Ray Exposure | Vacuum Adhesion Time (seconds) | Attachment of Scum |
|---|---|---|---|---|---|---|
| Example 1 | (1) | 10 | $5.0 \times 10^4$ sheets | $4.0 \times 10^4$ sheets | 25 | Absence |
| Example 11 | (14) | 10 | $5.5 \times 10^4$ sheets | $4.5 \times 10^4$ sheets | 25 | Absence |
| Example 12 | (15) | 12 | $4.5 \times 10^4$ sheets | $3.5 \times 10^4$ sheets | 25 | Absence |
| Example 13 | (16) | 12 | $4.0 \times 10^4$ sheets | $3.0 \times 10^4$ sheets | 30 | Absence |
| Example 14 | (17) | 12 | $5.0 \times 10^4$ sheets | $4.0 \times 10^4$ sheets | 25 | Absence |
| Example 15 | (18) | 16 | $6.0 \times 10^4$ sheets | $4.5 \times 10^4$ sheets | 25 | Absence |
| Example 16 | (19) | 14 | $6.0 \times 10^4$ sheets | $4.5 \times 10^4$ sheets | 20 | Absence |
| Example 17 | (20) | 14 | $7.0 \times 10^4$ sheets | $5.0 \times 10^4$ sheets | 20 | Absence |
| Example 18 | (21) | 14 | $6.0 \times 10^4$ sheets | $4.5 \times 10^4$ sheets | 20 | Absence |
| Example 19 | (22) | 20 | $5.5 \times 10^4$ sheets | $4.5 \times 10^4$ sheets | 30 | Absence |
| Example 20 | (23) | 16 | $5.5 \times 10^4$ sheets | $4.5 \times 10^4$ sheets | 22 | Absence |
| Example 21 | (24) | 16 | $6.5 \times 10^4$ sheets | $5.0 \times 10^4$ sheets | 22 | Absence |

(continued)

| | Lithographic Printing Plate Precursor | Number of Sheets of On-press Development | Printing Durability with UV Exposure | Printing Durability with Infrared Ray Exposure | Vacuum Adhesion Time (seconds) | Attachment of Scum |
|---|---|---|---|---|---|---|
| Example 22 | (25) | 16 | $5.0 \times 10^4$ sheets | $4.5 \times 10^4$ sheets | 22 | Absence |
| Comparative Example 4 | (26) | 30 | $3.0 \times 10^4$ sheets | $2.5 \times 10^4$ sheets | >60 | Absence |
| Comparative Example 5 | (27) | 25 | $3.5 \times 10^4$ sheets | $3.0 \times 10^4$ sheets | 35 | Presence |
| Comparative Example 6 | (28) | 25 | $3.5 \times 10^4$ sheets | $3.0 \times 10^4$ sheets | 40 | Presence |
| Comparative Example 7 | (29) | 40 | $3.5 \times 10^4$ sheets | $3.0 \times 10^4$ sheets | 40 | Absence |
| Comparative Example 8 | (30) | 40 | $3.5 \times 10^4$ sheets | $3.0 \times 10^4$ sheets | 40 | Absence |
| Comparative Example 9 | (31) | 40 | $3.5 \times 10^4$ sheets | $3.0 \times 10^4$ sheets | 50 | Absence |
| Comparative Example 10 | (32) | 40 | $3.5 \times 10^4$ sheets | $3.0 \times 10^4$ sheets | 40 | Absence |

INDUSTRIAL APPLICABILITY

According to the invention, in a plate making method comprising conducting exposure through a lith film and conducting on-press development, the printing durability and on-press development property become good, deposition of scum hardly occurs at the on-press development, and the vacuum adhesion property to a lith film becomes good.

## Claims

1. A plate making method of a lithographic printing plate comprising (1) preparing a lithographic printing plate precursor capable of forming an image with a semiconductor laser emitting an infrared ray having a wavelength from 760 to 1,200 nm which comprises a support and an image-recording layer containing a cyanine dye, a diphenyl iodonium salt or triphenyl sulfonium salt which may have a substituent on the phenyl group, a radical polymerizable compound and a polymer fine particle having a polyoxyalkylene chain in its side chain in this order, (2) placing a lith film on the lithographic printing plate precursor and reducing pressure so that the lith film is closely adhered to the lithographic printing plate precursor, (3) conducting UV exposure, and (4) mounting the exposed lithographic printing plate precursor on a cylinder of a printing machine and removing a non-image area of the image-recording layer with at least one of dampening water and ink.

2. The plate making method of a lithographic printing plate as claimed in Claim 1, wherein an oxygen-blocking layer is provided on the image-recording layer.

3. The plate making method of a lithographic printing plate as claimed in Claim 2, wherein the oxygen-blocking layer contains a water-soluble resin and at least one selected from a polymer fine particle having a polyoxyalkylene chain in its side chain, an inorganic spherical fine particle and an inorganic stratiform fine particle.

4. The plate making method of a lithographic printing plate as claimed in any one of Claims 1 to 3, wherein the polymer fine particle having a polyoxyalkylene chain in its side chain is a microgel.

5. The plate making method of a lithographic printing plate as claimed in Claim 3, wherein the inorganic spherical fine particle is a silica fine particle.

6. The plate making method of a lithographic printing plate as claimed in Claim 3, wherein the inorganic stratiform fine particle is mica.

7. The plate making method of a lithographic printing plate as claimed in Claim 1, wherein the average particle size of the polymer fine particle is in a range from 70 to 300 nm.

8. A printing method of a lithographic printing plate comprising (1) preparing a lithographic printing plate precursor which comprises a support and an image-recording layer capable of forming an image with a semiconductor laser emitting an infrared ray having a wavelength from 760 to 1,200 nm containing a cyanine dye, a diphenyl iodonium salt or triphenyl sulfonium salt which may have a substituent on the phenyl group, a radical polymerizable compound and a polymer fine particle having a polyoxyalkylene chain in its side chain in this order, (2) placing a lith film on the lithographic printing plate precursor and reducing pressure so that the lith film is closely adhered to the lithographic printing plate precursor, (3) conducting UV exposure, (4) mounting the exposed lithographic printing plate precursor on a cylinder of a printing machine and removing a non-image area of the image-recording layer with at least any of dampening water and ink, and (5) conducting printing.

**Patentansprüche**

1. Plattenherstellungsverfahren für eine Lithographiedruckplatte, umfassend (1) Vorbereiten eines Lithographiedruckplattenvorläufers, der in der Lage ist, ein Bild mit einem Halbleiterlaser zu bilden, der Infrarotstrahlen mit einer Wellenlänge von 760 bis 1.200 nm emittiert, welcher in dieser Reihenfolge einen Träger und eine Bildaufzeichnungsschicht umfasst, die einen Cyaninfarbstoff, ein Diphenyljodoniumsalz oder ein Triphenylsulfoniumsalz, welche einen Substituenten an der Phenylgruppe aufweisen können, eine radikalisch polymerisierbare Verbindung und einen Polymer-Feinpartikel mit einer Polyoxyalkylenkette in dessen Seitenkette umfasst, (2) Platzieren eines Lithofilms auf dem Lithographiedruckplattenvorläufer und Reduzieren des Drucks, so dass der Lithofilm dicht an dem Lithographiedruckplattenvorläufer anliegt, (3) Durchführen einer UV-Belichtung und (4) Montieren des belichteten Lithographiedruckplattenvorläufers auf einen Zylinder einer Druckmaschine und Entfernen eines Nicht-Bildbereichs der Bildaufzeichnungsschicht mit zumindest einem von Anfeuchtwasser und Tinte.

2. Plattenherstellungsverfahren für eine Lithographiedruckplatte gemäß Anspruch 1, worin auf der Bildaufzeichnungsschicht eine Sauerstoff-blockierende Schicht vorgesehen ist.

3. Plattenherstellungsverfahren für eine Lithographiedruckplatte gemäß Anspruch 2, worin die Sauerstoff-blockierende Schicht ein wasserlösliches Harz und zumindest eines enthält, ausgewählt aus einem Polymer-Feinpartikel mit einer Polyoxyalkylenkette in dessen Seitenkette, einem anorganischen sphärischen Feinpartikel und einem anorganischen Schichtverbindungs-Feinpartikel.

4. Plattenherstellungsverfahren für eine Lithographiedruckplatte gemäß irgendeinem der Ansprüche 1 bis 3, worin der Polymer-Feinpartikel mit einer Polyoxyalkylenkette in dessen Seitenkette ein Mikrogel ist.

5. Plattenherstellungsverfahren für eine Lithographiedruckplatte gemäß Anspruch 3, worin der anorganische sphärische Feinpartikel ein Silika-Feinpartikel ist.

6. Plattenherstellungsverfahren für eine Lithographiedruckplatte gemäß Anspruch 3, worin der anorganische Schichtverbindungs-Feinpartikel Glimmer ist.

7. Plattenherstellungsverfahren für eine Lithographiedruckplatte gemäß Anspruch 1, worin die mittlere Partikelgröße des Polymer-Feinpartikels im Bereich von 70 bis 300 nm liegt.

8. Druckverfahren mit einer Lithographiedruckplatte, umfassend (1) Vorbereiten eines Lithographiedruckplattenvorläufers, der in dieser Reihenfolge einen Träger und eine Bildaufzeichnungsschicht, die in der Lage ist, ein Bild mit einem Halbleiterlaser zu erzeugen, der Infrarotstrahlen mit einer Wellenlänge von 760 bis 1.200 nm emittiert, umfasst, enthaltend einen Cyaninfarbstoff, ein Diphenyljodoniumsalz oder ein Triphenylsulfoniumsalz, die einen Substituenten an der Phenylgruppe aufweisen können, eine radikalisch polymerisierbare Verbindung und einen Polymer-Feinpartikel mit einer Polyoxyalkylenkette in dessen Seitenkette, (2) Platzieren eines Lithofilms auf dem Lithographiedruckplattenvorläufer und Reduzieren des Drucks, so dass der Lithofilm dicht an dem Lithographiedruckplattenvorläufer anliegt, (3) Durchführen einer UV-Belichtung, (4) Montieren des belichteten Lithographiedruckplattenvorläufers auf einem Zylinder einer Druckmaschine und Entfernen eines Nicht-Bildbereichs der Bildaufzeichnungsschicht mit zumindest einem von Anfeuchtwasser und Tinte und (5) Durchführen des Druckens.

## Revendications

1. Procédé de fabrication de plaques d'une plaque d'impression lithographique comprenant (1) la préparation d'un précurseur de plaque d'impression lithographique capable de former une image avec un laser à semi-conducteur émettant un rayon infrarouge ayant une longueur d'onde allant de 760 à 1200 nm qui comprend un support et une couche d'enregistrement d'image contenant un colorant cyanine, un sel de diphényliodonium ou un sel de triphénylsulfonium qui peut avoir un substituant dans le groupe phényle, un composé polymérisable par voie radicalaire et une particule fine de polymère ayant une chaîne de polyoxyalkylène dans sa chaîne latérale dans cet ordre, (2) le placement d'un film lith sur le précurseur de plaque d'impression lithographique et la réduction de pression de sorte que le film lith adhère de près au précurseur de plaque d'impression lithographique, (3) la réalisation de l'exposition aux UV, et (4) le montage du précurseur de plaque d'impression lithographique exposé sur un cylindre d'une machine à imprimer et l'enlèvement d'une zone non-imagée de la couche d'enregistrement d'image avec au moins l'un parmi de l'eau de mouillage et de l'encre.

2. Procédé de fabrication de plaques d'une plaque d'impression lithographique selon la revendication 1, dans lequel une couche bloquant l'oxygène est fournie sur la couche d'enregistrement d'image.

3. Procédé de fabrication de plaques d'une plaque d'impression lithographique selon la revendication 2, dans lequel la couche bloquant l'oxygène contient une résine hydrosoluble et au moins l'une sélectionnée à partir d'une particule fine de polymère ayant une chaîne de polyoxyalkylène dans sa chaîne latérale, une particule fine sphérique inorganique et une particule fine stratiforme inorganique.

4. Procédé de fabrication de plaques d'une plaque d'impression lithographique selon l'une quelconque des revendications 1 à 3, dans lequel la particule fine de polymère ayant une chaîne de polyoxyalkylène dans sa chaîne latérale est un microgel.

5. Procédé de fabrication de plaques d'une plaque d'impression lithographique selon la revendication 3, dans lequel la particule fine sphérique inorganique est une particule fine de silice.

6. Procédé de fabrication de plaques d'une plaque d'impression lithographique selon la revendication 3, dans lequel la particule fine stratiforme inorganique est du mica.

7. Procédé de fabrication de plaques d'une plaque d'impression lithographique selon la revendication 1, dans lequel la taille moyenne de particules de la particule fine de polymère est dans une gamme de 70 à 300 nm.

8. Procédé d'impression d'une plaque d'impression lithographique comprenant (1) la préparation d'un précurseur de plaque d'impression lithographique qui comprend un support et une couche d'enregistrement d'image capable de former une image avec un laser à semi-conducteur émettant un rayon infrarouge ayant une longueur d'onde allant de 760 à 1200 nm contenant un colorant cyanine, un sel de diphényliodonium ou un sel de triphénylsulfonium qui peut avoir un substituant dans le groupe phényle, un composé polymérisable par voie radicalaire et une particule fine de polymère ayant une chaîne de polyoxyalkylène dans sa chaîne latérale dans cet ordre, (2) le placement d'un film lith sur le précurseur de plaque d'impression lithographique et la réduction de pression de sorte que le film lith adhère de près au précurseur de plaque d'impression lithographique, (3) la réalisation de l'exposition aux UV, (4) le montage du précurseur de plaque d'impression lithographique exposé sur un cylindre d'une machine à imprimer et l'enlèvement d'une zone non-imagée de la couche d'enregistrement d'image avec au moins l'un parmi de l'eau de mouillage et de l'encre, et (5) la réalisation de l'impression.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001277740 A
- JP 2001277742 A
- JP 2000039711 A
- JP 4166934 A
- JP 10500915 T
- JP 58182636 A
- JP 61008421 B
- US 20030064318 A
- WO 2008156552 A1
- JP 2007224229 A
- EP 2554395 A1
- JP 7021633 B
- JP 2001133969 A
- JP 2002040638 A
- JP 2002278057 A
- JP 2008195018 A
- JP 2007090850 A
- EP 104143 A
- US 20080311520 A
- JP 2150848 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2006297907 A
- JP 2007050660 A
- JP 2008284817 A
- JP 2006091479 A
- JP 10282679 A
- JP 2304441 A
- JP 2005125749 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A


### Non-patent literature cited in the description


- Polyurethane Jushi Handbook (Polyurethane Resin Handbook). The Nikkan Kogyo Shimbun, Ltd, 1987
- **J. V. CRIVELLO et al.** *Macromolecules,* 1977, vol. 10 (6), 1307